# EUROPEAN PATENT SPECIFICATION

(11) **EP 4 012 788 B1**
(45) Date of publication and mention of the grant of the patent: **03.01.2024**
(21) Application number: 20850286.4
(22) Date of filing: 05.08.2020
(51) Int. Cl.: H10N 10/13, H10N 10/17, H02N 11/00

(54) **THERMOELECTRIC CONVERSION ELEMENT**
THERMOELEKTRISCHES UMWANDLUNGSELEMENT
ÉLÉMENT DE CONVERSION THERMOÉLECTRIQUE

(30) Priority: 08.08.2019 JP 2019146670
(43) Date of publication of application: 15.06.2022
(73) Proprietor: Denka Company Limited, Tokyo 103-8338 (JP)
(72) Inventor: ASAMI, Takeshi, Tokyo 103-8338 (JP); GOTO, Yoshitsugu, Tokyo 103-8338 (JP)
(74) Representative: Gulde & Partner
(86) International application number: PCT/JP2020/029997
(87) International publication number: WO 2021/025059

(56) References cited:
- EP-A1- 3 035 397
- WO-A1-2015/046253
- WO-A1-2018/143185
- WO-A1-2018/143185
- JP-A- 2009 016 812
- JP-A- 2009 016 812

## Description

### Technical Field

The present disclosure relates to a thermoelectric conversion element.

### Background Art

A thermoelectric conversion element may be used to perform power generation using geothermal heat, exhaust heat of a factory, or the like. JP 4,895,293 B2 discloses an embodiment in which a flexible substrate having a pattern layer and composed of a resin layer and a metal layer is provided on both surfaces of a thermoelectric conversion module having a P-type thermoelectric element material and an N-type thermoelectric element material. In JP 4,895,293 B2, a metal layer included in one flexible substrate overlaps one electrode included in the thermoelectric conversion module, and a metal layer included in the other flexible substrate overlaps the other electrode included in the thermoelectric conversion module. In the above embodiment, by setting one flexible substrate to a high temperature state and setting the other flexible substrate to a low temperature state, a temperature difference is generated in a planar direction of the thermoelectric conversion module. Accordingly, an electromotive force is generated in the thermoelectric conversion module.

EP 3 035 397 A1 discloses a thermally conductive adhesive sheet comprising a base material comprising a high thermally conductive portion and a low thermally conductive portion; and an adhesive layer, wherein the adhesive layer is laminated on one face of the base material, and the other face of the base material is composed of a face of the low thermally conductive portion opposite to a face in contact with the adhesive layer and a face of the high thermally conductive portion opposite to a face in contact with the adhesive layer, or at least either the high thermally conductive portion or the low thermally conductive portion constitutes a portion of a thickness of the base material, and a method for producing the thermally conductive adhesive sheet, and an electronic device using the thermally conductive adhesive sheet. WO 2018/143185 A1 discloses a thermoelectric conversion module comprising: a film-type thermoelectric conversion element body having p-type thermoelectric conversion elements and n-type thermoelectric conversion elements joined in one direction in a plane; and heat conductors joined to where the p-type thermoelectric conversion elements and the n-type thermoelectric conversion elements are joined on one surface of the thermoelectric conversion element body. Insulation regions are disposed adjoining both sides of the heat conductors in said one direction and, if disposed on the heat source, have radiation reflecting bodies and/or radiation prevention bodies closer to the heat source than the thermoelectric conversion element body. In JP 2009 016812 A a thermoelectric conversion module is described which comprises boards provided on both sides of a single thermoelectric conversion unit body or its aggregate comprising one or more thermoelectric conversion units each of which has a p-type thermoelectric conversion element and an n-type thermoelectric conversion element connected to each other and which are two-dimensionally arrayed. The boards comprise low heat conductive portions covering the surfaces of the thermoelectric conversion units, and high heat conductive portions embedded in holes of the low heat conductive portions, and connected at their one-end sides to connection portions of p- and n-type thermoelectric conversion elements and exposed at their other-end sides from the holes in the surfaces of the low heat conductive portions.

### Summary of Invention

### Technical Problem

In the thermoelectric conversion element as described above, further improvement in thermoelectric conversion efficiency is required. Therefore, an object of an aspect of the present disclosure is to provide a thermoelectric conversion element capable of improving thermoelectric conversion efficiency.

### Solution to Problem

A thermoelectric conversion element according to the present invention is as follows.

A thermoelectric conversion element according to the present invention includes a first thermoelectric conversion module, and a pair of sheet members sandwiching the first thermoelectric conversion module, wherein the first thermoelectric conversion module includes: a first substrate having a first main face and a second main face located on the opposite side of the first main face; a first electrode provided on the first main face, a first n-type thermoelectric conversion layer electrically connected to the first electrode, a first p-type thermoelectric conversion layer in contact with the first n-type thermoelectric conversion layer, and a second electrode electrically connected to the first p-type thermoelectric conversion layer; and a sealing layer provided on the first main face. Each of the pair of sheet members includes a first high thermal conduction portion, a second high thermal conduction portion, and a low thermal conduction portion, the first electrode, the first n-type thermoelectric conversion layer, the first p-type thermoelectric conversion layer, and the second electrode are arranged in order along an alignment direction orthogonal to a thickness direction of the first substrate, the first electrode is overlapped with the first high thermal conduction portion which each of the pair of sheet members includes in the thickness direction, the second electrode is overlapped with the second high thermal contact layer which each of the pair of sheet members includes in the thickness direction, and a first contact portion between the first n-type thermoelectric conversion layer and the first p-type thermoelectric conversion layer is overlapped with the low thermal conduction portion which each of the pair of sheet members includes in the thickness direction.

According to one embodiment, the thermoelectric conversion element of the present invention further includes a second thermoelectric conversion module located on an opposite side of the first thermoelectric conversion module across one of the pair of the sheet member in the thickness direction, wherein the second thermoelectric conversion module includes: a second substrate including a third main face located on a side of the first thermoelectric conversion module in the thickness direction and a fourth main face located on an opposite side of the third main face; a third electrode provided on the fourth main face, a second n-type thermoelectric conversion layer electrically connected to the third electrode, a second p-type thermoelectric conversion layer in contact with the second n-type thermoelectric conversion layer, and a fourth electrode electrically connected to the second p-type thermoelectric conversion layer; and a second sealing layer provided on the fourth main face, the second sealing layer covering the third electrode, the second n-type thermoelectric conversion layer, the second p-type thermoelectric conversion layer, and the fourth electrode.

According to another embodiment of the thermoelectric conversion element of the present invention, the third electrode is overlapped with the first high thermal conduction portion which each of the pair of sheet members includes and the first electrode in the thickness direction, the fourth electrode is overlapped with the second high thermal conduction portion which each of the pair of sheet members includes and the second electrode in the thickness direction, and a second contact portion between the second n-type thermoelectric conversion layer and the second p-type thermoelectric conversion layer is overlapped with the low thermal conduction portion which each of the pair of sheet members includes in the thickness direction.

According to another embodiment of the thermoelectric conversion element of the present invention, the third electrode is overlapped with the second high thermal conduction portion which each of the pair of sheet members includes and the second electrode in the thickness direction, the fourth electrode is overlapped with the first high thermal conduction portion which each of the pair of sheet members includes and the first electrode in the thickness direction, and a second contact portion between the second n-type thermoelectric conversion layer and the second p-type thermoelectric conversion layer is overlapped with the low thermal conduction portion which each of the pair of sheet members includes in the thickness direction.

According to a further embodiment of the thermoelectric conversion element of the present invention, the second thermoelectric conversion module is electrically connected to the first thermoelectric conversion module.

According to a further embodiment of the thermoelectric conversion element of the present invention, the second sealing layer constitutes an outermost surface located on the fourth main face.

According to a preferred embodiment, the thermoelectric conversion module further includes a sheet member different from the pair of sheet members, wherein the sheet member is located on an opposite side of the first thermoelectric conversion module across the second thermoelectric conversion module in the thickness direction.

According to a further embodiment of the thermoelectric conversion element of the present invention, a thermal conductivity of the low thermal conduction portion is 0.2W/mK or less.

According to a preferred embodiment, the thermal conductivity of the low thermal conduction portion in the thermoelectric conversion element is 0.08W/mK or less.

According to a further embodiment of the thermoelectric conversion element of the present invention, a thermal conductivity of the first high thermal conduction portion and a thermal conductivity of the second high thermal conduction portion is 5W/mK.

According to a further embodiment of the thermoelectric conversion element of the present invention, a thermal conductivity of the first electrode and a thermal conductivity of the second electrode is 5W/mK or more.

According to a further embodiment of the thermoelectric conversion element of the present invention, the substrate has a flexibility.

According to a further embodiment of the thermoelectric conversion element of the present invention, an interval between the first high thermal conduction portion and the first contact portion along the alignment direction is 5 times or more longer than a length of the first high thermal conduction portion along the thickness direction, and an interval between the second high thermal conduction portion and the first contact portion along the alignment direction is 5 times or more longer than a length of the second high thermal conduction portion along the thickness direction.

### Advantageous Effects of Invention

According to an aspect of the present invention, a thermoelectric conversion element capable of improving thermoelectric conversion efficiency can be provided.

### Brief Description of Drawings

FIG. 1 is a schematic cross-sectional view showing a thermoelectric conversion element according to the present embodiment.
FIG. 2 is an extracted view of a portion of FIG. 1.
FIG. 3 is a schematic cross-sectional view illustrating a thermoelectric conversion element according to a first modification.
FIG. 4 is a schematic cross-sectional view illustrating a thermoelectric conversion element according to a second modification.
FIG. 5 is a schematic cross-sectional view showing a first simulation condition.
(a) and (b) of FIG. 6 are graphs showing results of the first simulation.
FIG. 7 is a schematic cross-sectional view showing a second simulation condition.
FIG. 8 is a graph showing results of the second simulation.
FIG. 9 is a schematic cross-sectional view showing a third simulation condition.
FIG. 10 is a graph showing results of the third simulation.
(a) of FIG. 11 is a schematic cross-sectional view of a thermoelectric conversion element according to a first reference example, and (b) of FIG. 11 is a schematic cross-sectional view of a thermoelectric conversion element according to a second reference example.

### Description of Embodiments

Hereinafter, an embodiment according to one aspect of the present disclosure will be described in detail with reference to the accompanying drawings. In the following description, the same reference numerals are used for the same element or element having the same function, and redundant description is omitted. In the present specification, "identical" and words similar thereto are not limited to "completely identical."

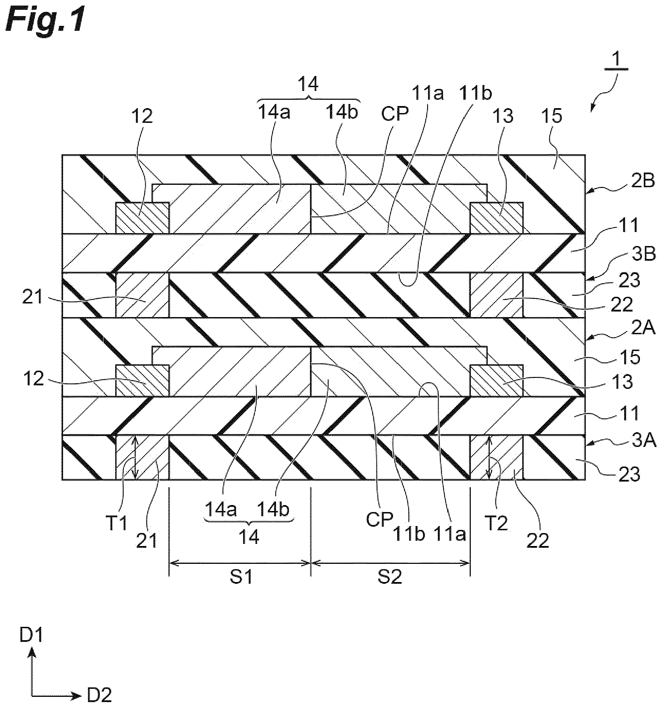

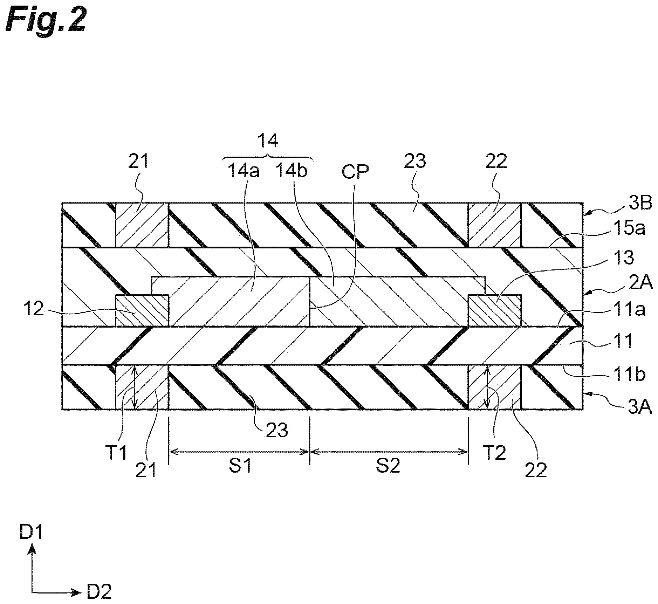

First, a configuration of a thermoelectric conversion element according to a present embodiment will be described with reference to FIGS. 1 and 2. FIG. 1 is a schematic cross-sectional view showing a thermoelectric conversion element according to the present embodiment. FIG. 2 is an extracted view of a portion of FIG. 1. The thermoelectric conversion element 1 shown in FIG. 1 is an element capable of generating electric power by being supplied with heat from the outside. The thermoelectric conversion element 1 is, for example, an element that converts heat into electricity by using a temperature difference in the thermoelectric conversion element 20. The thermoelectric conversion element 1 is a so-called in-plane type element. Therefore, the thermoelectric conversion element 1 is likely to be more excellent in workability and flexibility than, for example, a π-type element (cross-plane type element). Therefore, the thermoelectric conversion element 1 can be provided along the side surface of a cylindrical pipe or the like used for recovering factory exhaust heat, for example. That is, the thermoelectric conversion element 1 can be easily disposed at various positions. Therefore, the thermoelectric conversion element 1 is used, for example, as a power source of a plant sensor using exhaust heat. In addition, the contact resistance between the thermoelectric conversion material included in the thermoelectric conversion element 1 and the electrode is likely to be lower than that of the π-type module. In the following, the temperature of each component of the thermoelectric conversion element 1 is measured under natural convection conditions of air.

The thermoelectric conversion element 1 includes thermoelectric conversion modules 2A and 2B and sheet members 3A and 3B. The thermoelectric conversion modules 2A and 2B and the sheet members 3A and 3B are alternately stacked. In this embodiment, a sheet member 3A, a thermoelectric conversion module 2A (first thermoelectric conversion module), a sheet member 3B, and a thermoelectric conversion module 2B (second thermoelectric conversion module) are disposed in order. The thermoelectric conversion modules 2A and 2B have the same shape, and the sheet members 3A and 3B have the same shape. That is, the thermoelectric conversion modules 2A and 2B have the same components, and the sheet members 3A and 3B have the same components. A direction in which the thermoelectric conversion modules 2A and 2B and the sheet members 3A and 3B are stacked corresponds to a direction along the thicknesses of the thermoelectric conversion modules 2A and 2B and the sheet members 3A and 3B. Hereinafter, a direction along the thicknesses of the thermoelectric conversion modules 2A and 2B and the sheet members 3A and 3B will be simply referred to as a direction D1. A view from the thickness direction D1 corresponds to a plan view. FIG. 2 shows a thermoelectric conversion module 2A and a pair of sheet members 3A and 3B sandwiching the thermoelectric conversion module 2A. A thermoelectric conversion element according to an aspect of the present disclosure may have a structure shown in FIG. 2.

The thermoelectric conversion module 2A is a thermoelectric conversion part in the thermoelectric conversion element 1, and includes a substrate 11 (first substrate), electrodes 12,13 (first and second electrodes), an element portion 14, and a sealing layer 15 (first sealing layer).

The substrate 11 is, for example, a sheet member made of a resin showing heat resistance and flexibility, and has a substantially flat plate shape. Examples of the resin constituting the substrate 11 include a (meth)acrylic based resin, a (meth)acrylonitrile based resin, a polyamide based resin, a polycarbonate based resin, a polyether based resin, a polyester based resin, an epoxy based resin, an organosiloxane based resin, a polyimide based resin, and a polysulfone based resin. The thickness of the substrate 11 is, for example, 5µm or more and 50µm or less. The thermal conductivity of the substrate 11 is, for example, 0.1W/mK (corresponding to 0.1 watts per meter per Kelvin and 0.1W× m⁻¹ × K⁻¹) or more and 0.3W/mK or less. When the thermal conductivity of the substrate 11 is 0.3W/mK or less, a temperature difference may occur in the element portion 14. The substrate 11 has a main face 11a (first main face) and a main face 11b (second main face) located on an opposite side of the main face 11a. The main faces 11a and 11b are surfaces intersecting the direction along the thickness of the substrate 11. The shape of the main faces 11a and 11b is not particularly limited, and is, for example, a polygonal shape, a circular shape, an elliptical shape, or the like.

The electrode 12 is a member constituting a terminal included in the thermoelectric conversion element 1, and is a conductor provided on the main face 11a of the substrate 11. The electrode 12 is a conductor made of, for example, a metal, an alloy, or a conductive resin. When the electrode 12 is made of a metal or an alloy, the electrode 12 is formed on the substrate 11 by various dry methods, for example. Examples of the dry method include a physical vapor deposition method (PVD method), patterning of a metal foil or an alloy foil, and the like. The electrode 12 may be formed using a nano-paste or the like in which metal particles are dispersed. The shape of the electrode 12 in a plan view is not particularly limited, and is, for example, a polygonal shape, a circular shape, an elliptical shape, or the like. The thickness of the electrode 12 is, for example, 6µm or more and 70µm or less. The thermal conductivity of the electrode 12 is, for example, 5W/mK or more. In this case, the electrode 12 is likely to be easily heated from the outside. The thermal conductivity of the electrode 12 may be, for example, 30W/mK or more.

The electrode 13 is a member constituting a terminal included in the thermoelectric conversion element 1 similarly to the electrode 12, and is a conductor provided on the main face 11a of the substrate 11. The electrode 13 is separated from the electrode 12. The electrode 13 is formed at the same time as the electrode 12. Therefore, the electrode 13 is made of the same material as the electrode 12. The shape of the electrode 13 in a plan view is not particularly limited, and is, for example, a polygonal shape, a circular shape, an elliptical shape, or the like. Similarly to the electrode 12, the thermal conductivity of the electrode 13 is, for example, 5W/mK or more. The thermal conductivity of the electrode 13 may be, for example, 30W/mK or more.

The element portion 14 is a member in which thermoelectric conversion is performed in the thermoelectric conversion element 1. The shape of the element portion 14 in a plan view is not particularly limited, and is, for example, a polygonal shape, a circular shape, an elliptical shape, or the like. The element portion 14 includes an n-type thermoelectric conversion layer 14a and a p-type thermoelectric conversion layer 14b. In the present embodiment, the n-type thermoelectric conversion layer 14a and the p-type thermoelectric conversion layer 14b have the same shape.

The n-type thermoelectric conversion layer 14a is disposed on the main face 11a of the substrate 11 and electrically connected to the electrode 12. In this embodiment, the n-type thermoelectric conversion layer 14a is located between the electrodes 12,13 and is in contact with the electrode 12. The n-type thermoelectric conversion layer 14a covers a part of the electrode 12. The n-type thermoelectric conversion layer 14a is, for example, an n-type semiconductor layer. The n-type thermoelectric conversion layer 14a includes, for example, a composite of an inorganic substance and an organic substance or a composite of a plurality of organic substances. Examples of the inorganic substance include titanium sulfide (TiS₂), bismuth tellurium (Bi₂Te₃), skutterudite, and nickel (Ni). Examples of the organic substance include an n-type single-walled carbon nanotube (SWCNT) and tetrathiafulvalene-tetracyanoquinodimethane (TTF-TCNQ). The n-type thermoelectric conversion layer 14a is formed by various dry methods or wet methods, for example. Examples of the wet method include a doctor blade method, a dip coating method, a spray coating method, a spin coating method, and an inkjet method. A thickness of the n-type thermoelectric conversion layer 14a is, for example, 9µm or more and 200µm or less. A thermal conductivity of the n-type thermoelectric conversion layer 14a is, for example, 0.01W/mK or more and 0.5W/mK or less. In this case, a temperature gradient may be easily formed in the n-type thermoelectric conversion layer 14a. The thickness of the n-type thermoelectric conversion layer 14a corresponds to the thickness of the portion not overlapping the electrode 12 in the thickness direction D1.

The p-type thermoelectric conversion layer 14b is provided on the main face 11a of the substrate 11 and is in contact with the n-type thermoelectric conversion layer 14a. In the present embodiment, the p-type thermoelectric conversion layer 14b is located between the electrodes 12, 13, and is located on the opposite side of the electrode 12 with the n-type thermoelectric conversion layer 14a interposed therebetween. The p-type thermoelectric conversion layer 14b covers a part of the electrode 13 and is in contact with the part. The p-type thermoelectric conversion layer 14b is, for example, a p-type semiconductor layer. The p-type thermoelectric conversion layer 14b includes, for example, a carbon nanotube and a conductive polymer different from the carbon nanotube. The carbon nanotube is, for example, a p-type SWCNT. Examples of the conductive polymer include poly (3,4-ethylenedioxythiophene) (PEDOT) and polystyrene sulfonate (PSS). In the p-type thermoelectric conversion layer 14b, the carbon nanotube and the conductive polymer may aggregate. The p-type thermoelectric conversion layer 14b may include a porous structure in which carbon nanotubes are bonded to each other by a conductive polymer.

The p-type thermoelectric conversion layer 14b is formed by, for example, various dry or wet methods, similarly to the n-type thermoelectric conversion layer 14a. A thickness of the p-type thermoelectric conversion layer 14b is, for example, 9µm or more and 200µm or less. A thermal conductivity of the p-type thermoelectric conversion layer 14b is, for example, 0.01W/mK or more and 0.5W/mK or less. In this case, a temperature gradient may be easily formed in the p-type thermoelectric conversion layer 14b. The thickness of the p-type thermoelectric conversion layer 14b corresponds to the thickness of the portion not overlapping the electrode 13 in the thickness direction D1.

The sealing layer 15 is a resin layer for protecting the electrode 12, 13, the n-type thermoelectric conversion layer 14a, and the p-type thermoelectric conversion layer 14b. The sealing layer 15 is provided on the main face 11a and covers the electrodes 12, 13, the n-type thermoelectric conversion layer 14a, and the p-type thermoelectric conversion layer 14b. Examples of the resin constituting the sealing layer 15 include a (meth)acrylic based resin, a (meth)acrylonitrile based resin, a polyamide based resin, a polycarbonate based resin, a polyether based resin, a polyester based resin, an epoxy based resin, an organosiloxane based resin, a polyimide based resin, and a polysulfone based resin. A thickness of the sealing layer 15 is, for example, 50µm or more and 200µm or less, and is smaller than intervals S1 and S2 described later. A thermal conductivity of the sealing layer 15 is, for example, 0.1W/mK or more and 0.5W/mK or less.

The electrode 12, the n-type thermoelectric conversion layer 14a, the p-type thermoelectric conversion layer 14b, and the electrode 13 are disposed in order along an alignment direction D2 orthogonal to the thickness direction D1. Therefore, the electrode 12 is located on a side of one end of the thermoelectric conversion element 1 in the alignment direction D2, and the electrode 13 is located on a side of the other end of the thermoelectric conversion element 1 in the alignment direction D2. Therefore, in view of the difference in thermal conductivity between the constituent elements of the thermoelectric conversion element 1, for example, when the thermoelectric conversion element 14 is heated from a side of the substrate 11, the temperature of the portion in contact with the electrode 13 is likely to be the highest in the n-type thermoelectric conversion layer 14a, and the temperature of the portion in contact with the electrode 12 is likely to be the highest in the p-type thermoelectric conversion layer 14b. The temperature of a contact portion CP between the n-type thermoelectric conversion layer 14a and the p-type thermoelectric conversion layer 14b is likely to be the lowest. Therefore, in each of the n-type thermoelectric conversion layer 14a and the p-type thermoelectric conversion layer 14b, a temperature gradient may occur along the alignment direction D2. In a plan view, the contact portion CP extends, for example, along a direction intersecting both the thickness direction D1 and the alignment direction D2. In a plan view, the contact portion CP may have a linear shape, a wavy line shape, or an arc shape.

A length of the n-type thermoelectric conversion layer 14a along the alignment direction D2 is longer than a length of the sealing layer 15 along the thickness direction D1. The length of the n-type thermoelectric conversion layer 14a along the alignment direction D2 is, for example, 5 times or more, or 10 times or more longer than the length of the sealing layer 15 along the thickness direction D1. As described above, the thermal conductivity of the sealing layer 15 is, for example, 0.1W/mK or more and 0.5W/mK or less. For this reason, for example, heat conducted from the electrode 12 to the sealing layer 15 more easily reaches the upper face 15a of the sealing layer 15 than the contact portion CP. In other words, the contact portion CP is less likely to conduct heat through the sealing layer 15. Rather, the heat of the contact portion CP tends to be discharged to the outside through the sealing layer 15.

Like the thermoelectric conversion module 2A, the thermoelectric conversion module 2B is a thermoelectric conversion unit in the thermoelectric conversion element 1. As described above, since the thermoelectric conversion modules 2A and 2B have the same components, the thermoelectric conversion module 2B also includes a substrate 11 (second substrate), an electrode 12 (third electrode), an electrode 13 (fourth electrode), an element portion 14, and a sealing layer 15 (second sealing layer). In the thermoelectric conversion element 1, the sealing layer 15 constitutes the outermost surface located on the main face 11a (fourth main face) of the substrate 11. In the present embodiment, the outermost layer is formed only of the sealing layer 15.

In the thermoelectric conversion modules 2A and 2B, the electrodes 12 are overlapped with each other in the thickness direction D1, the electrodes 13 are overlapped with each other in the thickness direction D1, the n-type thermoelectric conversion layers 14a are overlapped with each other in the thickness direction D1, and the p-type thermoelectric conversion layers 14b are overlapped with each other in the thickness direction D1. In the present embodiment, the thermoelectric conversion module 2A is electrically connected to the thermoelectric conversion module 2B, but is not limited thereto. When the thermoelectric conversion module 2A is electrically connected to the thermoelectric conversion module 2B, the thermoelectric conversion modules 2A and 2B may be connected in series or in parallel.

The sheet member 3A is a member disposed between the thermoelectric conversion module 2A and a heat source, and is provided on the main face II b of the substrate 11. Therefore, the heat generated from the heat source is conducted to the thermoelectric conversion module 2A through the sheet member 3A. The sheet member 3A has a first high thermal conduction portion 21, a second high thermal conduction portion 22, and a low thermal conduction portion 23.

The first high thermal conduction portion 21 and the second high thermal conduction portion 22 are portions showing higher thermal conductivity than the low thermal conduction portion 23, and are spaced apart from each other. The first high thermal conduction portion 21 is overlapped with the electrode 13 in the thickness direction D1, and the second high thermal conduction portion 22 is overlapped with the electrode 12 in the thickness direction D1. The shapes of the first high thermal conduction portion 21 and the second high thermal conduction portion 22 in a plan view are not particularly limited, and are, for example, polygonal shape, circular shape, elliptical shape, or the like. In a plan view, the shape of the first high thermal conduction portion 21 and the shape of the electrode 12 may be the same as or different from each other. Similarly, in a plan view, the shape of the second high thermal conduction portion 22 and the shape of the electrode 13 may be the same as or different from each other. Each of the first high thermal conduction portion 21 and the second high thermal conduction portion 22 includes, for example, a metal (silver, copper, aluminum, or the like), carbon, or the like. Each of the first high thermal conduction portion 21 and the second high thermal conduction portion 22 may include a ceramic such as boron nitride or aluminum nitride exhibiting high thermal conductivity. The thermal conductivity of each of the first high thermal conduction portion 21 and the second high thermal conduction portion 22 is, for example, 5W/mK or more and 400W/mK or less. Accordingly, when the sheet member 3A is heated, heat is well transferred to the electrode 12 and the electrode 13 through the first high thermal conduction portion 21 and the second high thermal conduction portion 22, respectively.

In order to increase the heat transfer efficiency from the first high thermal conduction portion 21 to the electrode 12, the electrode 12 may be located inside the edge of the first high thermal conduction portion 21 in a plan view, or the edge of the electrode 12 may be completely overlapped with the edge of the first high thermal conduction portion 21. Similarly, in a plan view, the electrode 13 may be located inside the edge of the second high thermal conduction portion 22, or the edge of the electrode 13 and the edge of the second high thermal conduction portion 22 may be completely overlapped with each other. From the viewpoint of widening the temperature gradient inside the n-type thermoelectric conversion layer 14a along the alignment direction D2, the first high thermal conduction portion 21 may be located closer to a side of one end in the alignment direction D2 than the electrode 12. That is, in a plan view, the edge of the first high thermal conduction portion 21 on the side of one end may be located outside the edge of the electrode 12 on the side of one end. Similarly, the second high thermal conduction portion 22 may be located closer to a side of the other end in the alignment direction D2 than the electrode 13.

A length T1 of the first high thermal conduction portion 21 along the thickness direction D1 is, for example, not less than 50µm and not more than 500µm. In a plan view, an interval S1 from the first high thermal conduction portion 21 (a contact portion between the first high thermal conduction portion 21 and the low thermal conduction portion 23) to the contact portion CP along the alignment direction D2 is, for example, 5 times or more or 10 times or more longer than the length T1 of the first high thermal conduction portion 21. In this case, a temperature gradient in the n-type thermoelectric conversion layer 14a along the alignment direction D2 may be favorably generated. Similarly, a length T2 of the second high thermal conduction portion 22 along the thickness direction D1 is, for example, not less than 50µm and not more than 500µm. In a plan view, an interval S2 from the second high thermal conduction portion 22 (a contact portion between the second high thermal conduction portion 22 and the low thermal conduction portion 23) to the contact portion CP along the alignment direction D2 is, for example, 5 times or more or 10 times or more longer than the length T2 of the second high thermal conduction portion 22. In this case, a temperature gradient in the p-type thermoelectric conversion layer 14b along the alignment direction D2 may be favorably generated. Depending on the length T1 of the first high thermal conduction portion 21, the interval S1 may be 5 times or more, 10 times or more, or 20 times or less longer than the length T1. Similarly, the interval S2 may be 5 times or more, 10 times or more, or 20 times or less longer than the length T2. For example, when the length T1 is greater than or equal to 100µm and less than or equal to 200µm, the interval S1 is preferably greater than or equal to 5 times the length T1, more preferably greater than or equal to 10 times the length T1.

The low thermal conduction portion 23 is a portion having a lower thermal conductivity than the first high thermal conduction portion 21 and the second high thermal conduction portion 22, and is a main portion of the sheet member 3. The low thermal conduction portion 23 is overlapped with at least the contact portion CP in the thickness direction D1 and covers most of the main face 11b. In the present embodiment, the low thermal conduction portion 23 is overlapped with most of the n-type thermoelectric conversion layer 14a and the p-type thermoelectric conversion layer 14b in addition to the contact portion CP in the thickness direction D1. The low thermal conduction portion 23 fills the gap between the first high thermal conduction portion 21 and the second high thermal conduction portion 22 in the alignment direction D2. The low thermal conduction portion 23 includes, for example, cellulose nanofibers (CNF), silica aerogel, or the like. The low thermal conduction portion 23 may be a foam body.

The thermal conductivity of the low thermal conduction portion 23 is significantly lower than the thermal conductivity of the first high thermal conduction portion 21 and the thermal conductivity of the second high thermal conduction portion 22, and is, for example, 0.01W/mK or more and 0.2W/mK or less. Accordingly, when the sheet member 3A is heated, a portion of the thermoelectric conversion module 2A located on the main face 11a and overlapped with the low thermal conduction portion 23 is less likely to be heated. Accordingly, since the contact portion CP and the vicinity thereof are less likely to be heated, the temperature gradient in the n-type thermoelectric conversion layer 14a and the temperature gradient in the p-type thermoelectric conversion layer 14b along the alignment direction D2 may be favorably generated. From the viewpoint of better generating the temperature gradient, the thermal conductivity of the low thermal conduction portion 23 may be 0.08W/mK or less.

The sheet member 3A is formed directly on the main face 11b, for example. In this case, each of the first high thermal conduction portion 21, the second high thermal conduction portion 22, and the low thermal conduction portion 23 is formed by various dry or wet methods. Alternatively, the sheet member 3A may be attached to the main face 11b by an adhesive (not shown). Examples of the adhesive include a (meth)acrylic based resin, a (meth)acrylonitrile based resin, a polyamide based resin, a polycarbonate based resin, a polyether based resin, a polyester based resin, an epoxy based resin, an organosiloxane based resin, a polyimide based resin, and a polysulfone based resin. The thermal conductivity of the adhesive is, for example, approximately the same as the thermal conductivity of the substrate 11.

The sheet member 3B is a member disposed between the thermoelectric conversion modules 2A and 2B in the thickness direction D1. The sheet member 3B is provided on the sealing layer 15 of the thermoelectric conversion module 2A and on the main face 11b (third main face) of the substrate 11 of the thermoelectric conversion module 2B. The sheet member 3B is formed directly on the main face 11b of the substrate 11 of the thermoelectric conversion module 2B, for example. In this case, the sheet member 3B is attached to the sealing layer 15 of the thermoelectric conversion module 2A by an adhesive (not shown). Alternatively, the sheet member 3B is attached to both the thermoelectric conversion modules 2A and 2B by an adhesive (not shown).

As described above, since the sheet members 3A and 3B have the same configuration, the sheet member 3B also has a first high thermal conduction portion 21, a second high thermal conduction portion 22, and a low thermal conduction portion 23. The first high thermal conduction portion 21 of the sheet member 3B is located between the electrodes 13 of the thermoelectric conversion modules 2A and 2B in the thickness direction D1, and the second high thermal conduction portion 22 of the sheet member 3B is located between the electrodes 12 of the thermoelectric conversion modules 2A and 2B in the thickness direction D1. Therefore, when the sheet member 3A is heated, heat is well transferred from the electrode 12 of the thermoelectric conversion module 2A to the electrode 12 of the thermoelectric conversion module 2B through the first high thermal conduction portion 21 of the sheet member 3B. When the sheet member 3A is heated, heat is well transferred from the electrode 13 of the thermoelectric conversion module 2A to the electrode 13 of the thermoelectric conversion module 2B through the second high thermal conduction portion 22 of the sheet member 3B.

Meanwhile, the low thermal conduction portion 23 of the sheet member 3B is located at least between the contact portions CP of the element portions 14 of the thermoelectric conversion modules 2A and 2B in the thickness direction D1. Therefore, when the sheet member 3A is heated, heat transfer from the element portion 14 of the thermoelectric conversion module 2A to the element portion 14 of the thermoelectric conversion module 2B is well suppressed by the low thermal conduction portion 23 of the sheet member 3B.

In summary, in the thermoelectric conversion element 1, the electrodes 12 of the thermoelectric conversion modules 2A, 2B are overlapped with the first high thermal conduction portions 21 of the sheet members 3A, 3B in the thickness direction D1, and the electrodes 13 of the thermoelectric conversion modules 2A, 2B are overlapped with the first high thermal conduction portions 21 of the sheet members 3A, 3B in the thickness direction D1. A contact portion CP (first contact portion) between the n-type thermoelectric conversion layer 14a (first n-type thermoelectric conversion layer) and the p-type thermoelectric conversion layer 14b (first p-type thermoelectric conversion layer) in the thermoelectric conversion module 2A and a contact portion CP (second contact portion) between the n-type thermoelectric conversion layer 14a (second n-type thermoelectric conversion layer) and the p-type thermoelectric conversion layer 14b (second p-type thermoelectric conversion layer) in the thermoelectric conversion module 2B are overlapped with the low thermal conduction portion 23 of the sheet members 3A and 3B in the thickness direction D1.

The thermoelectric conversion element 1 may further include a configuration other than the above. For example, the thermoelectric conversion element 1 may include a wiring for electrically connecting the thermoelectric conversion modules 2A and 2B, a wiring for electrically connecting another thermoelectric conversion elements, a wiring for extracting power to an external circuit, and the like.

In the thermoelectric conversion module 2A of the thermoelectric conversion element 1 according to the present embodiment described above, the electrode 12 is overlapped with the first high thermal conduction portion 21 in the thickness direction D1, the electrode 13 is overlapped with the second high thermal conduction portion 22 in the thickness direction D1, and the contact portion CP between the n-type thermoelectric conversion layer 14a and the p-type thermoelectric conversion layer 14b is overlapped with the low thermal conduction portion 23 in the thickness direction D1. Accordingly, when the thermoelectric conversion module 2A is heated from a side of the sheet member 3A, in the n-type thermoelectric conversion layer 14a, the temperature of the contact portion CP is likely to be the lowest, and the temperature of the portion closest to the electrode 12 is likely to be the highest. Similarly, in the p-type thermoelectric conversion layer 14b, the temperature of the contact portion CP is likely to be the lowest, and the temperature of the portion closest to the electrode 13 is likely to be the highest. In this case, for example, both the temperature gradient of the n-type thermoelectric conversion layer 14a in the alignment direction D2 and the temperature gradient of the p-type thermoelectric conversion layer 14b in the alignment direction D2 are likely to be larger than when one electrode side is set to a high temperature state and a side of the other electrode is set to a low temperature state in the alignment direction D2. In other words, both the temperature difference between both ends of the n-type thermoelectric conversion layer 14a in the alignment direction D2 and the temperature difference between both ends of the p-type thermoelectric conversion layer 14b in the alignment direction D2 are likely to be larger than when the side of one electrode is set to a high temperature state and the side of the other electrode is set to a low temperature state in the alignment direction D2. Therefore, according to the thermoelectric conversion element 1 of the present embodiment, the thermoelectric conversion efficiency can be improved.

Moreover, in the present embodiment, in each of the thermoelectric conversion modules 2A and 2B, the electrode 12 is overlapped with the first high thermal conduction portion 21 of the sheet members 3A and 3B in the thickness direction D1, the electrode 13 is overlapped with the second high thermal conduction portion 22 of the sheet members 3A and 3B in the thickness direction D1, and the contact portion CP is overlapped with the low thermal conduction portion 23 of the sheet members 3A and 3B in the thickness direction D1. Accordingly, also in the thermoelectric conversion module 2B, in the n-type thermoelectric conversion layer 14a, the temperature of the contact portion CP is likely to be the lowest, and the temperature of the portion closest to the electrode 12 is likely to be the highest. In the p-type thermoelectric conversion layer 14b, the temperature of the contact portion CP is likely to be the lowest, and the temperature of the portion closest to the electrode 13 is likely to be the highest. Accordingly, in each of the thermoelectric conversion modules 2A and 2B stacked along the thickness direction D1, the temperature gradient in the element portion 14 is likely to expand. Therefore, according to the thermoelectric conversion element 1 of the present embodiment, it is possible to achieve both further improvement of the thermoelectric conversion efficiency in the thermoelectric conversion element 1 and downsizing in a plan view.

In this embodiment, the thermoelectric conversion module 2A may be electrically connected to the thermoelectric conversion module 2B. In this case, the electromotive force or current capacity of the thermoelectric conversion element 1 can be increased.

In this embodiment, the sealing layer 15 of the thermoelectric conversion module 2B constitutes the outermost surface located on the main face 11a. In this case, the temperature gradient of the element portion 14 in the thermoelectric conversion module 2B is likely to be maintained.

In the present embodiment, the thermal conductivity of the low thermal conduction portion 23 may be 0.2W/mK or less. In this case, the temperature difference between both ends of each of the n-type thermoelectric conversion layer 14a and the p-type thermoelectric conversion layer 14b in the alignment direction D2 can be favorably widened. When the thermal conductivity of the low thermal conduction portion 23 is 0.08W/mK or less, the temperature difference can be more favorably widened.

In the present embodiment, the thermal conductivity of the first high thermal conduction portion 21 and the second high thermal conduction portion 22 may be 5W/mK or more. In this case, the temperature difference between both ends of each of the n-type thermoelectric conversion layer 14a and the p-type thermoelectric conversion layer 14b in the alignment direction D2 can be favorably widened.

In the present embodiment, the thermal conductivity of the electrodes 12, 13 may be 5W/mK or more. In this case, the temperature difference between both ends of each of the n-type thermoelectric conversion layer 14a and the p-type thermoelectric conversion layer 14b in the alignment direction D2 can be favorably widened.

In the present embodiment, the substrate 11 has a flexibility. Therefore, the thermoelectric conversion element 1 can have a flexibility. Therefore, for example, the thermoelectric conversion element 1 can be easily provided along the surface of the cylindrical pipe. That is, it is possible to alleviate the restriction on the mounting position of the thermoelectric conversion element 1.

In this embodiment, the interval S1 from the first high thermal conduction portion 21 to the contact portion CP along the alignment direction D2 is at least 5 times or at least 10 times longer than the length T1 of the first high thermal conduction portion 21 along the thickness direction D1, and the interval S2 from the second high thermal conduction portion 22 to the contact portion CP along the alignment direction D2 is at least 5 times or at least 10 times longer than the length T2 of the second high thermal conduction portion 22 along the thickness direction D1. Therefore, the temperature difference between both ends of each of the n-type thermoelectric conversion layer 14a and the p-type thermoelectric conversion layer 14b in the alignment direction D2 can be favorably widened.

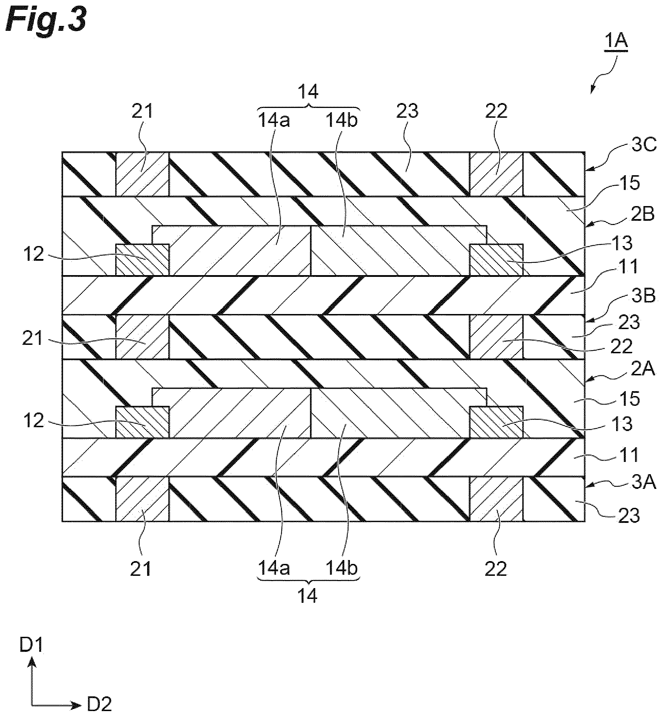

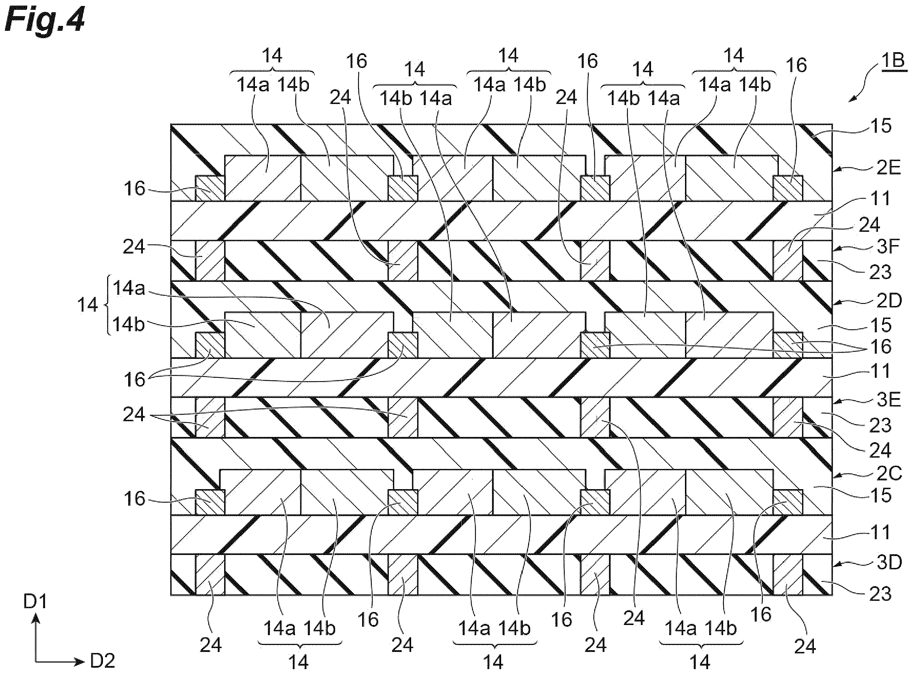

Hereinafter, a modification of the above embodiment will be described with reference to FIGS. 3 and 4.

FIG. 3 is a schematic cross-sectional view of a thermoelectric conversion element according to a first modification. As shown in FIG. 3, the thermoelectric conversion element 1A according to the first modification includes a sheet member 3C different from the sheet members 3A and 3B in addition to the configuration of the thermoelectric conversion element 1. The sheet member 3C is located on the opposite side of the thermoelectric conversion module 2B from the thermoelectric conversion module 2A in the thickness direction D1. Thus, the thermoelectric conversion module 2B is sandwiched between the sheet members 3B and 3C in the thickness direction D1. The sheet member 3C is configured as a part of the outermost layer in the thermoelectric conversion element 1A.

The sheet member 3C has the same components as those of the sheet members 3A and 3B. That is, the sheet member 3C includes a first high thermal conduction portion 21, a second high thermal conduction portion 22, and a low thermal conduction portion 23. The first high thermal conduction portion 21 of the sheet member 3C is overlapped with the electrode 12 of the thermoelectric conversion modules 2A, 2B and the first high thermal conduction portion 21 of the sheet members 3A, 3B in the thickness direction D1. The first high thermal conduction portion 21 of the sheet member 3C is overlapped with the electrode 13 of the thermoelectric conversion modules 2A, 2B and the second high thermal conduction portion 22 of the sheet members 3A, 3B in the thickness direction D1.

Also in the above-described first modification, the same effects as those of the above-described embodiment are achieved.

FIG. 4 is a schematic cross-sectional view of a thermoelectric conversion element according to a second modification. As shown in FIG. 4, a thermoelectric conversion element 1B according to the second modification includes thermoelectric conversion modules 2C to 2E and sheet members 3D to 3F. In the present second modification, the thermoelectric conversion modules 2C to 2E are electrically connected to each other, but the present disclosure is not limited thereto.

Each of the thermoelectric conversion modules 2C to 2E includes a substrate 11, a plurality of element portions 14, a sealing layer 15, and a plurality of electrodes 16. The electrodes 16 and the element portions 14 provided on the substrate 11 and covered with the sealing layer 15 are alternately arranged in the alignment direction D2. Therefore, some of the electrodes 16 are in contact with both the n-type thermoelectric conversion layer 14a and the p-type thermoelectric conversion layer 14b. In the thermoelectric conversion element 1B, n-type thermoelectric conversion layers 14a and p-type thermoelectric conversion layers 14b are alternately stacked along the thickness direction D1. Therefore, for example, the electrodes 16 in contact with only the n-type thermoelectric conversion layer 14a and the electrodes 16 in contact with only the p-type thermoelectric conversion layer 14b are alternately stacked along the thickness direction D1. The electrodes 16 are conductors corresponding to the electrode 12 or the electrode 13 in the above embodiment.

The sheet member 3D is located at one side of the thermoelectric conversion module 2C in the thickness direction D1. The sheet member 3E is located on the other side of the thermoelectric conversion module 2C (and on one side of the thermoelectric conversion module 2D) and between the thermoelectric conversion modules 2C, 2D in the thickness direction D1. The sheet member 3F is located on the other side of the thermoelectric conversion module 2D (and on one side of the thermoelectric conversion module 2E) and between the thermoelectric conversion modules 2D and 2E in the thickness direction D1. The sheet members 3D to 3F include a low thermal conduction portion 23 and high thermal conduction portions 24. The high thermal conduction portion 24s are portions overlapping the electrodes 16 in the thickness direction D1. The high thermal conduction portions 24 correspond to the first high thermal conduction portion 21 or the second high thermal conduction portion 22 in the above embodiment.

In order to increase the efficiency of heat transfer from the high thermal conduction portion 24 to the electrode 16, the electrode 16 may be located inside the edge of the high thermal conduction portion 24 in a plan view, or the edge of the electrode 16 may be completely overlapped with the edge of the high thermal conduction portion 24. From the viewpoint of widening the temperature gradient along the alignment direction D2 in each element portion 14, the high thermal conduction portion 24 may be located in the edge of the electrode 16 in contact with both the n-type thermoelectric conversion layer 14a and the p-type thermoelectric conversion layer 14b in a plan view.

In the second modification described above, the same operation and effect as those of the embodiment and the first modification are achieved.

In the following, results of simulating a temperature change in the element when a position or a characteristic of a constituent element included in the thermoelectric conversion element is changed will be described. In the following simulations, a two dimensional model is set. In the following simulation, an EXCEL model in which a basic differential equation of two dimensional heat conduction was applied to differentiation was used. A finite volume method was applied as a method of differentiation.

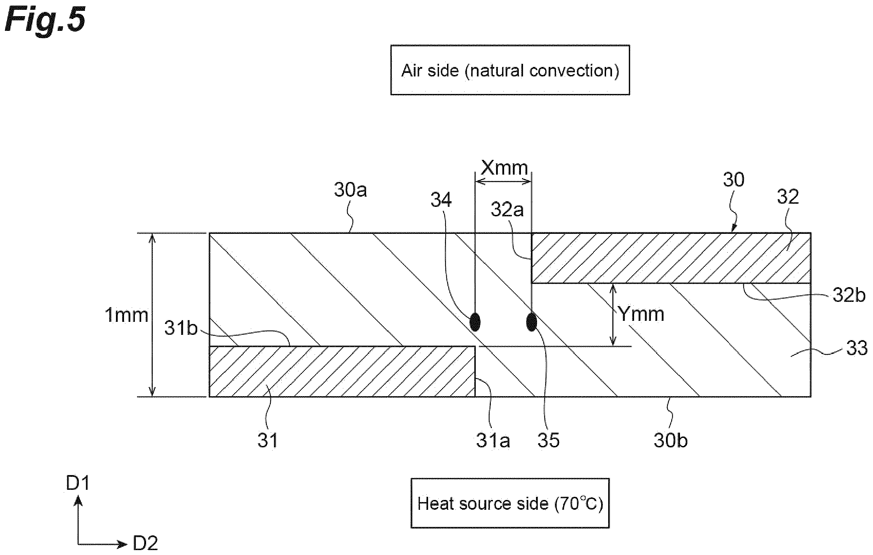

FIG. 5 is a schematic cross-sectional view showing a first simulation condition. As shown in FIG. 5, a model 30 in the first simulation includes a high thermal conduction portions 31, 32 and a low thermal conduction portion 33 similarly to the sheet member 3 of the above embodiment. The high thermal conduction portion 31 is exposed on one side in the thickness direction D1 and is located at one end of the model 30 in the alignment direction D2. The high thermal conduction portion 32 is exposed on the other side in the thickness direction D1 and is located at the other end of the model 30 in the alignment direction D2. In the model 30, the dimension of the high thermal conduction portions 31,32 along the thickness direction D1 was set to be the same. The low thermal conduction portion 33 had a sheet shape with a thickness of 1mm, and was integrated with the high thermal conduction portions 31, 32. The thermal conductivity of the high thermal conduction portions 31, 32 was set to 398W/mK, and the thermal conductivity of the low thermal conduction portion 33 was set to 0.3W/mK.

In the model 30, the interval between the high thermal conduction portions 31, 32 along the alignment direction D2 is defined as an interval X (mm), and the interval between the high thermal conduction portions 31, 32 along the thickness direction D1 is defined as an interval Y (mm) (interval Y is less than 1). When the interval X is 0mm, the edge 31a on the center side of the high thermal conduction portion 31 in the alignment direction D2 is overlapped with the edge 32a on the center side of the high thermal conduction portion 32 in the alignment direction D2 in the thickness direction D1. When the interval Y is 0mm, the edge 31b on the center side of the high thermal conduction portion 31 in the thickness direction D1 is overlapped with the edge 32b on the center side of the high thermal conduction portion 32 in the thickness direction D1 in the alignment direction D2.

In the model 30, two temperature evaluation points 34, 35 are set. The temperature evaluation point 34 is located at the center of the interval Y on the edge 31a on the center side of the high thermal conduction portion 31 in the thickness direction D1. Therefore, when the interval Y is 0mm, the temperature evaluation point 34 is overlapped with the intersection of the edges 31a and 31b. The temperature evaluation point 35 is located at the center of the interval Y on the edge 32a on the center side of the high thermal conduction portion 32 in the thickness direction D1. Therefore, when the interval Y is 0mm, the temperature evaluation point 35 is overlapped with the intersection of the edges 32a and 32b.

In the thickness direction D1, the one side of the model 30 is set as a side of the heat source, and the other side of the model 30 is set as a side of air. In the first simulation, the temperature on the side of the heat source is set to 70°C, and the side of air is set to room temperature (23°C). In the first simulation, the surface 30b of the model 30 located on the side of heat source in the thickness direction D1 is heated by natural convection, and the surface 30a of the model 30 located on the side of air in the thickness direction D1 is cooled by natural convection.

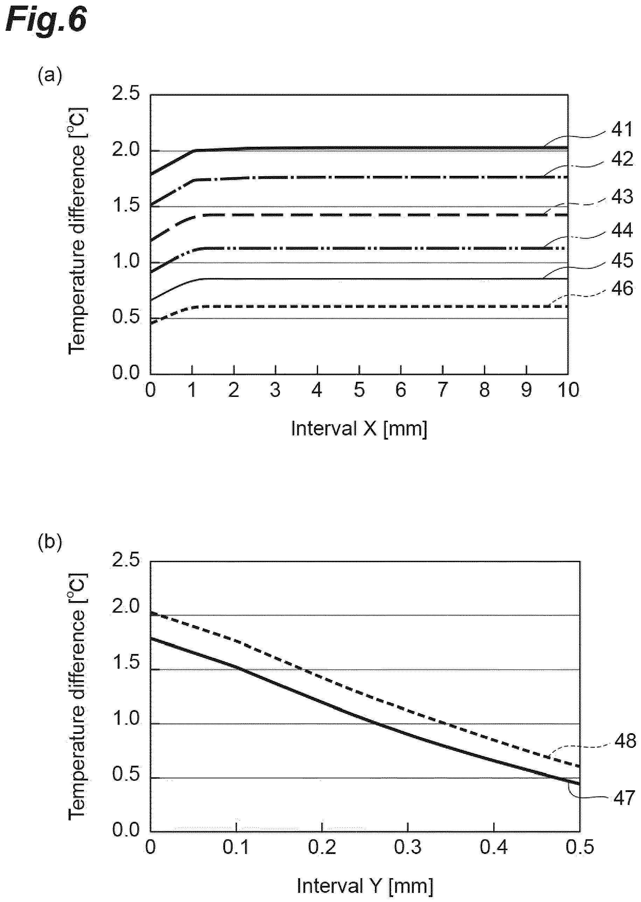

(a) and (b) of FIG. 6 are graphs showing results of the first simulation. (a) of FIG. 6 is a graph showing a change in the temperature difference at the temperature evaluation points 34, 35 when the interval X is changed. In (a) of FIG. 6, the horizontal axis represents the interval X, and the vertical axis represents the temperature difference at the temperature evaluation points 34, 35. A plot 41 shows a simulation result when the interval Y is 0mm, a plot 42 shows a simulation result when the interval Y is 0.1mm, a plot 43 shows a simulation result when the interval Y is 0.2mm, a plot 44 shows a simulation result when the interval Y is 0.3mm, a plot 45 shows a simulation result when the interval Y is 0.4mm, and a plot 46 shows a simulation result when the interval Y is 0.5mm. As shown in (a) of FIG. 6, under the condition that the interval X is 1mm or less, the temperature difference at the temperature evaluation points 34, 35 increases as the interval X increases, regardless of the value of the interval Y Under the condition that the interval X was 1mm or more and less than 2mm, the temperature difference was unlikely to increase even when the interval X was increased. Under the condition that the interval X was 2mm or more, the temperature difference was not substantially changed even when the interval X was widened regardless of the value of the interval Y This suggests that, for example, in the sheet member 3 of the above embodiment, when the distance between the first high thermal conduction portion 21 and the second high thermal conduction portion 22 in the alignment direction D2 is 2mm or more, the distance between the first high thermal conduction portion 21 and the second high thermal conduction portion 22 in the thickness direction D1 may not be considered.

(b) of FIG. 6 is a graph showing a change in the temperature difference of the temperature evaluation points 34, 35 when the interval Y is changed. In (b) of FIG. 6, the horizontal axis represents the interval Y, and the vertical axis represents the temperature difference at the temperature evaluation points 34, 35. A plot 47 shows a simulation result when the interval X is 0mm, and a plot 48 shows a simulation result when the interval X is 10mm. As shown in (b) of FIG. 6, regardless of the value of the interval X, the shorter the interval Y, the larger the temperature difference at the temperature evaluation points 34, 35. This suggests that, for example, in the model 30, the shorter the interval Y of the high thermal conduction portions 31, 32 in the thickness direction D1, the larger the temperature difference.

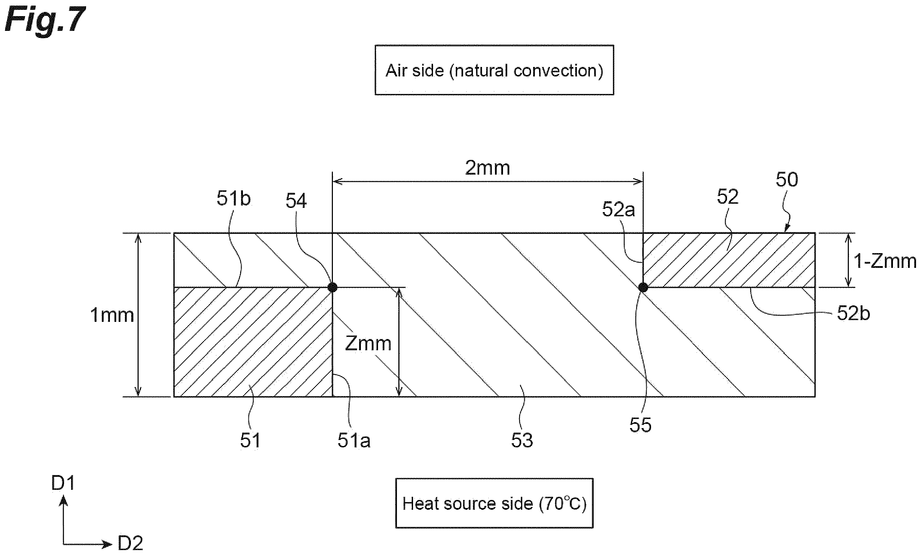

FIG. 7 is a schematic cross-sectional view showing a second simulation condition. As shown in FIG. 7, a model 50 in the simulation of second includes a high thermal conduction portions 51,52 and a low thermal conduction portion 53 similarly to the model 30. The positions where the high thermal conduction portions 51, 52 and the low thermal conduction portion 53 are provided in the model 50, and the thermal conductivities thereof are the same as those of the model 30. In model 50, the interval between the high thermal conduction portions 51, 52 along the alignment direction D2 was set to 2mm. The length of the high thermal conduction portion 52 along the thickness direction D1 was set to Z mm, and the length of the high thermal conduction portion 51 along the thickness direction D1 was set to 1-Z mm. The ambient temperature condition of the model 50 is the same as that in the first simulation.

In the model 50, two temperature evaluation points 54, 55 are set. The temperature evaluation point 54 is located at the intersection of the center side edge 51a of the high thermal conduction portion 51 along the alignment direction D2 and the center side edge 51b of the high thermal conduction portion 51 along the thickness direction D1. The temperature evaluation point 55 is located at the intersection of the center side edge 52a of the high thermal conduction portion 52 along the alignment direction D2 and the center side edge 52b of the high thermal conduction portion 52 along the thickness direction D1.

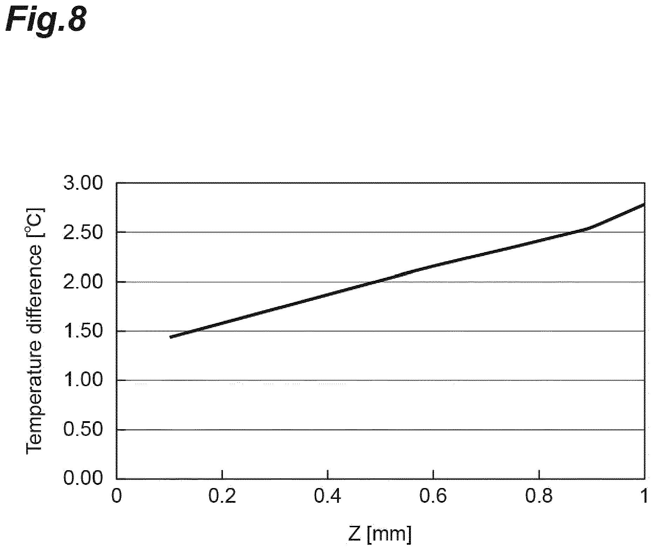

FIG. 8 is a graph showing results of the second simulation, and shows a change in temperature difference of the temperature evaluation points 54, 55 when the height of the high thermal conduction portion 51 along the thickness direction D1 is changed. In FIG. 8, the horizontal axis represents the length Z, and the vertical axis represents the temperature difference at the temperature evaluation points 54, 55. As shown in FIG. 8, the larger the length along the thickness direction D1 of the high thermal conduction portion 51 located on the side of heat source in the thickness direction D1, the larger the temperature difference. From this result, it is suggested that in order to widen the temperature difference of the temperature evaluation points 54, 55 along the alignment direction D2 in the model 50, it is effective to increase the thickness of the high thermal conductive portion located on the side of heat source as much as possible.

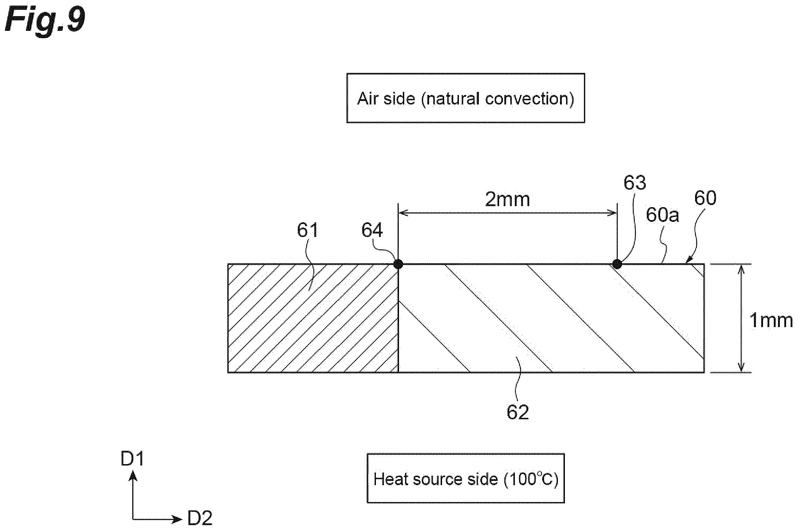

FIG. 9 is a schematic cross-sectional view showing a third simulation condition. Based on the first and second simulation results, the model used in the third simulation has a structure in which it is estimated that the largest temperature difference occurs in the alignment direction D2. Specifically, as shown in FIG. 9, a model 60 in the third simulation includes a high thermal conduction portion 61 and a low thermal conduction portion 62. The high thermal conduction portion 61 and the low thermal conduction portion 62 are arranged in order along the alignment direction D2 and are integrated with each other. The dimensions of the high thermal conduction portion 61 and the low thermal conduction portion 62 along the thickness direction D1 are 1mm. The thermal conductivity of the high thermal conduction portion 61 is set to 398W/mK.

In the thickness direction D1, the one side of the model 60 is set as the side of heat source, and the other side of the model 60 is set as the side of air. In the third simulation, unlike the first simulation, the temperature on the side of heat source is set to 100 °C. On the other hand, the side of air has the same conditions as in the first simulation.

In the model 60, a temperature evaluation point 63 located on surface 60a of the model 60 is set. The temperature evaluation point 63 is located on the low thermal conduction portion 62 at a distance of 2mm along the alignment direction D2 from the contact portion 64 between the high thermal conduction portion 61 and the low thermal conduction portion 62. Therefore, the temperature of temperature evaluation point 63 indicates the temperature of surface 60a when the model 60 is heated (more specifically, the temperature of surface 60a formed of the low thermal conduction portion 62).

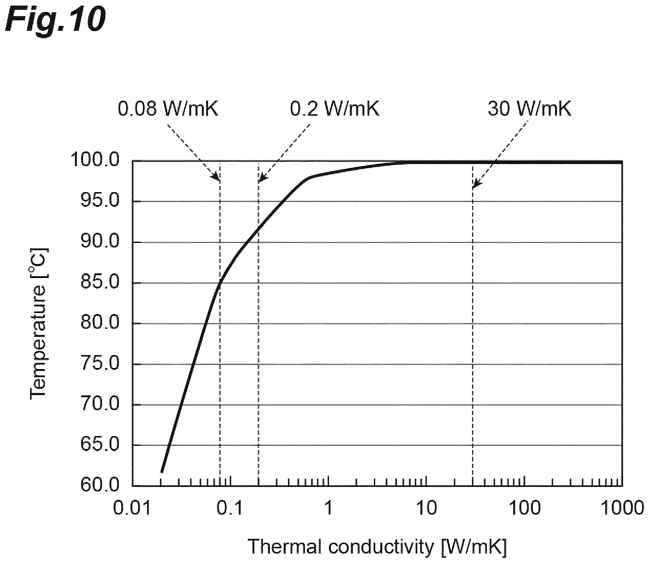

FIG. 10 is a graph showing results of the third simulation, and shows a temperature change of the temperature evaluation point 63 when the heat conductivity of the low thermal conduction portion 62 is changed. In FIG. 10, the horizontal axis represents the thermal conductivity of the low thermal conduction portion 62, and the vertical axis represents the temperature of the temperature evaluation point 63. As shown in FIG. 10, the lower the thermal conductivity of the low thermal conduction portion 62, the lower the temperature of the temperature evaluation point 63. When the thermal conductivity of the low thermal conduction portion 62 was 0.2W/mK, the temperature difference between the heat source and the temperature evaluation point 63 was about 8°C. When the thermal conductivity of the low thermal conduction portion 62 was 0.08W/mK, the temperature difference between the heat source and the temperature evaluation point 63 was about 15°C. Meanwhile, when the thermal conductivity of the low thermal conduction portion 62 was 30W/mK or more, the temperature difference between the heat source and the temperature evaluation point 63 was almost 0. This suggests that, for example, when the thermal conductivity of the low thermal conduction portion 23 included in the sheet member 3 is 0.2W/mK or less, the low thermal conduction portion 23 is likely to exhibit good thermal insulation properties, and when the thermal conductivity of the low thermal conduction portion 23 is 0.08W/mK or less, the low thermal conduction portion 23 is likely to exhibit better thermal insulation properties.

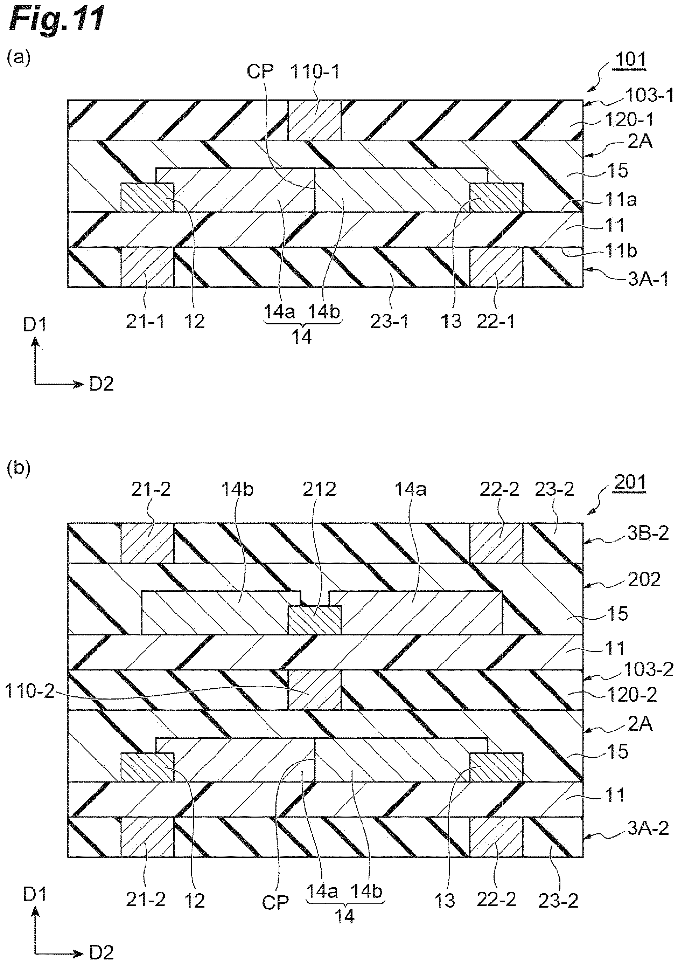

Next, simulation results of the maximum temperature difference in the element portion when the configuration of the thermoelectric conversion element is changed will be described. (a) of FIG. 11 is a schematic cross-sectional view of a thermoelectric conversion element according to a first reference example, and (b) of FIG. 11 is a schematic cross-sectional view of a thermoelectric conversion element according to a second reference example.

The thermoelectric conversion element 101 shown in (a) of FIG. 11 includes a thermoelectric conversion module 2A and sheet members 3A-1, 103-1. The sheet member 3A-1 has the same shape as the sheet member 3, and includes a first high thermal conduction portion 21-1, a second high thermal conduction portion 22-1, and a low thermal conduction portion 23-1. The thicknesses of the sheet members 3A and 3A-1 along the thickness direction D1 may be different from each other. The sheet member 103-1 includes a high thermal conduction portion 120-1 and a low thermal conduction portion 110-1 provided on the sealing layer 15 of the thermoelectric conversion module 2A. The high thermal conduction portion 110-1 is provided to improve heat dissipation of the n-type thermoelectric conversion layer 14a and the p-type thermoelectric conversion layer 14b, and is overlapped with the contact portion CP in the thickness direction D1. The center of the high thermal conduction portion 110-1 in the alignment direction D2 is overlapped with the contact portion CP in the thickness direction D1. The low thermal conduction portion 120-1 is a sheet member provided so as to reduce heat dissipation of the electrodes 12,13 and their vicinity. The low thermal conduction portion 120-1 surrounds the high thermal conduction portion 110-1 in a direction orthogonal to the thickness direction D1, and is overlapped with the electrodes 12, 13, the first high thermal conduction portion 21-1, and the first high thermal conduction portion 22-1 in the thickness direction D1. Lengths of the high thermal conduction portion 110-1 and the low thermal conduction portion 120-1 along the thickness direction D1 are the same.

The thermoelectric conversion element 201 shown in (b) of FIG. 11 includes thermoelectric conversion modules 2A and 202 and sheet members 3A-2, 3B-2, 103-2. In the thermoelectric conversion element 201, a sheet member 3A-2, a thermoelectric conversion module 2A, a sheet member 103-2, a thermoelectric conversion module 202, and a sheet member 3B-2 are stacked in order. The sheet member 3A-2, 3B-2 has the same shape as the sheet members 3A and 3A-1, and includes a first high thermal conduction portion 21-2, a second high thermal conduction portion 22-2, and a low thermal conduction portion 23-2. That is, the sheet members 3A-2, 3B-2 have the same or substantially the same shape. Thicknesses of the sheet members 3A-2, 3B-2 and the thicknesses of the sheet members 3A and 3A-1 along the thickness direction D1 may be different from each other along the thickness direction D1. The sheet member 103-2 has the same shape as the sheet member 103-1 and includes a high thermal conduction portion 110-2 and a low thermal conduction portion 120-2. The sheet members 103-1, 103-2 may have different thicknesses (lengths along the thickness direction D1).

The thermoelectric conversion module 202 includes a substrate 11, an electrode 212, an n-type thermoelectric conversion layer 14a, a p-type thermoelectric conversion layer 14b, and a sealing layer 15. The electrode 212 is overlapped with the contact portion CP of the thermoelectric conversion module 2A and the high thermal conduction portion 110-2 of the sheet member 103-2 in the thickness direction D1. Therefore, when the thermoelectric conversion element 201 is heated from a side of the sheet member 3A-2 in the thickness direction D1, the electrode 212 is heated mainly by heat transferred through the element portion 14 and the high thermal conduction portion 110-2 of the thermoelectric conversion module 2A. In the alignment direction D2, an n-type thermoelectric conversion layer 14a is provided on one end side of the electrode 212, and a p-type thermoelectric conversion layer 14b is provided on the other end side of the electrode 212. In the thermoelectric conversion module 202, the n-type thermoelectric conversion layer 14a and the p-type thermoelectric conversion layer 14b are separated from each other.

In this simulation, in the thermoelectric conversion elements 1, 101, 201, the length of the substrate 11 along the thickness direction D1 was set to 50µm, the length of the sheet members 3A and 3B along the thickness direction D1 were set to 300µm, the lengths of the sheet members 3A-1, 103-1 along the thickness direction D1 were set to 400µm, and the lengths of the sheet members 3A-2, 3B-2, 103-2 along the thickness direction D1 were set to 200µm. The lengths of the electrodes 12, 13, 212 along the thickness direction D1 were set to 25µm, the lengths of the n-type thermoelectric conversion layer 14a and the p-type thermoelectric conversion layer 14b along the thickness direction D1 were set to 100µm, the maximum length of the sealing layer 15 along the thickness direction D1 was set to 150µm, the lengths of the first high thermal conduction portion 21, the second high thermal conduction portion 22, and the low thermal conduction portion 23 along the thickness direction D1 were set to 300µm, the lengths of the first high thermal conduction portion 21-1, the second high thermal conduction portion 22-1, and the low thermal conduction portion 23-2 along the thickness direction D1 were set to 400µm, and the lengths of the first high thermal conduction portion 21-2, the second high thermal conduction portion 22-2, and the low thermal conduction portion 23-2 along the thickness direction D1 were set to 200µm. Further, the lengths of the high thermal conduction portion 110-1 and the low thermal conduction portion 120-1 along the thickness direction D1 were set to 400µm, and the lengths of the high thermal conduction portion 110-2 and the low thermal conduction portion 120-2 along the thickness direction D1 were set to 300µm.

In addition, the lengths of thermoelectric conversion modules 2A, 2B, 202 and sheet members 3A, 3A-1, 3A-1, 3B, 3B-2, 103-1, 103-2 along the alignment direction D2 were set to 15mm, the lengths of electrodes 12, 13, 212 along the alignment direction D2 were set to 3mm, the lengths of the n-type thermoelectric conversion layer 14a and the p-type thermoelectric conversion layer 14b along the alignment direction D2 were set to 2.5mm, and the lengths of the first high thermal conduction portions 21, 21-1, 21-2 and the second high thermal conduction portions 22, 22-1, 22-2 along the alignment direction D2 were set to 3mm. Further, the lengths of the high thermal conduction portions 110-1, 110-2 along the alignment direction D2 were set to 3mm.

In this simulation, in the thermoelectric conversion elements 1, 101, 201, the thermal conductivities of the substrate 11 and the sealing layer 15 were set to 0.3W/mK, the thermal conductivities of the electrodes 12, 13, 212 were set to 398W/mK, the thermal conductivities of the n-type thermoelectric conversion layer 14a and the p-type thermoelectric conversion layer 14b were set to 0.5W/mK, the thermal conductivities of the first high thermal conduction portions 21, 21-1, 21-2 and the second high thermal conduction portions 22, 22-1, 22-2 were set to 5W/mK, and the thermal conductivities of the low thermal conduction portions 23, 23-1, 23-2 were set to 0.05W/mK. The thermal conductivities of the high thermal conduction portions 110-1, 110-2 were set to 5W/mK, and the thermal conductivities of the low thermal conduction portions 120-1, 120-2 were set to 0.05W/mK.

In the thermoelectric conversion elements 1, 101, 201, the temperature on the side of the heat source were set to 100°C, and the temperature on the side of air is set to room temperature (23°C), similarly to the third simulation described above. The temperature of the exposed surfaces of the sheet members 3A, 3A-1, 3A-2 crossing the thickness direction D1 was also set to 100°C.

In the thermoelectric conversion elements 1, 101, 201 set under the above-described conditions, the maximum temperature difference of the element portion 14 was simulated. In the thermoelectric conversion element 201, the maximum temperature difference of one of the n-type thermoelectric conversion layer 14a and the p-type thermoelectric conversion layer 14b was simulated. As a result, in the thermoelectric conversion element 1, the maximum temperature difference of the element portion 14 of the thermoelectric conversion module 2A was 3.193°C, and the maximum temperature difference of the element portion 14 of the thermoelectric conversion module 2B was 6.628°C. The maximum temperature difference of the element portion 14 of the thermoelectric conversion element 101 was 4.909°C. In the thermoelectric conversion element 201, the maximum temperature difference of the element portion 14 of the thermoelectric conversion module 2A was 2.793°C, and the maximum temperature difference of the thermoelectric conversion module 202 was 1.168°C. From this, the total temperature difference of thermoelectric conversion element 1 was 9.821°C, and the total temperature difference of thermoelectric conversion element 201 was 3.961°C.

From the above results, it was suggested that a configuration including the configuration of the thermoelectric conversion element 101 and having a plurality of thermoelectric conversion modules stacked along the thickness direction (for example, the thermoelectric conversion element 201) is likely to have lower thermoelectric conversion efficiency than the configuration of the thermoelectric conversion element 1. In other words, it was suggested that the power generation capacity per unit area of the configuration (for example, the thermoelectric conversion element 201) including the configuration of the thermoelectric conversion element 101 and in which the plurality of thermoelectric conversion modules are stacked along the thickness direction is likely to be lower than that of the configuration of the thermoelectric conversion element 1.

A plurality of element portions along the alignment direction may be provided on the substrate by appropriately combining the embodiment and the second modification. The first modification and the second modification may be appropriately combined.

In the above-described embodiment and the above-described second modification, the outermost layer is formed only of the sealing layer, but the present disclosure is not limited thereto. For example, the outermost layer may include the sealing layer and a member different from the sealing layer. Alternatively, the outermost layer may include a separate sheet member including a low thermal conduction portion.

In the above-described embodiment and the above-described modification, the electrodes are formed at the same time, however, no limited thereto.

### Reference Signs List

1, 1A, 1B, 101, 201; thermoelectric conversion element
2A to 2E, 202; thermoelectric conversion module
3A to 3F, 3A-1, 3A-2, 3B-2, 103-1, 103-2; sheet member
11; substrate
11a, 11b; main surface
12, 13, 16, 212; electrode
14; element portion
14a; n-type thermoelectric conversion layer
14b; p-type thermoelectric conversion layer
15; sealing layer
21, 21-1, 21-2; first high thermal conduction portion
22, 22-1 ,22-2; second high thermal conduction portion
23, 23-1, 23-2; low thermal conduction portion
24; high thermal conduction portion
110-1, 110-2; high thermal conduction portion
120-1, 120-2; low thermal conduction portion
CP; contact portion
S1, S2; interval
T1; length of first high thermal conduction portion
T2; length of second high thermal conduction portion.

## Claims

1. A thermoelectric conversion element (1, 1A, 1B, 101, 201) comprising:
a first thermoelectric conversion module (2A to 2E, 202); and
a pair of sheet members (3A to 3F, 3A-1, 3A-2, 3B-2, 103-1, 103-2) sandwiching the first thermoelectric conversion module (2Ato 2E, 202),
wherein the first thermoelectric conversion module (2A to 2E, 202) includes:
a first substrate (11) including a first main face (11a, 11b) and a second main face (11a, 11b) located on the opposite side of the first main face (11a, 11b);
a first electrode (12, 13, 16, 212) provided on the first main face (11a, 11b), a first n-type thermoelectric conversion layer (14a) electrically connected to the first electrode (12, 13, 16, 212), a first p-type thermoelectric conversion layer (14b) in contact with the first n-type thermoelectric conversion layer (14a), and a second electrode (12, 13, 16, 212) electrically connected to the first p-type thermoelectric conversion layer (14b); and
a sealing layer (15) provided on the first main face (11a, 11b), the sealing layer (15) covering the first electrode (12, 13, 16, 212), the first n-type thermoelectric conversion layer (14a), the first p-type thermoelectric conversion layer (14b), and the second electrode (12, 13, 16, 212),
wherein each of the pair of sheet members (3A to 3F, 3A-1, 3A-2, 3B-2, 103-1, 103-2) includes a first high thermal conduction portion (21, 21-1, 21-2), a second high thermal conduction portion (22, 22-1 ,22-2), and a low thermal conduction portion (23, 23-1, 23-2),
wherein the first electrode (12, 13, 16, 212), the first n-type thermoelectric conversion layer (14a), the first p-type thermoelectric conversion layer (14b), and the second electrode (12, 13, 16, 212) are arranged in order along an alignment direction orthogonal to a thickness direction of the first substrate (11),
wherein the first electrode (12, 13, 16, 212) is overlapped with the first high thermal conduction portion (21, 21-1, 21-2) which each of the pair of sheet members (3A to 3F, 3A-1, 3A-2, 3B-2, 103-1, 103-2) includes in the thickness direction,
wherein the second electrode (12, 13, 16, 212) is overlapped with the second high thermal conduction portion (22, 22-1 ,22-2) which each of the pair of sheet members (3A to 3F, 3A-1, 3A-2, 3B-2, 103-1, 103-2) includes in the thickness direction, and
wherein a first contact portion (CP) between the first n-type thermoelectric conversion layer (14a) and the first p-type thermoelectric conversion layer (14b) is overlapped with the low thermal conduction portion (23, 23-1, 23-2) which each of the pair of sheet members (3A to 3F, 3A-1, 3A-2, 3B-2, 103-1, 103-2) includes in the thickness direction.

2. The thermoelectric conversion element (1, 1A, 1B, 101, 201) according to claim 1, further comprising a second thermoelectric conversion module (2A to 2E, 202) located on an opposite side of the first thermoelectric conversion module (2A to 2E, 202) across one of the pair of the sheet members (3A to 3F, 3A-1, 3A-2, 3B-2, 103-1, 103-2) in the thickness direction,
wherein the second thermoelectric conversion module (2A to 2E, 202) includes:
a second substrate (11) including a third main face (11a, 11b) located on a side of the first thermoelectric conversion module (2A to 2E, 202) in the thickness direction and a fourth main face (11a, 11b) located on an opposite side of the third main face (11a, 11b);
a third electrode (12, 13, 16, 212) provided on the fourth main face (11a, 11b), a second n-type thermoelectric conversion layer (14a) electrically connected to the third electrode (12, 13, 16, 212), a second p-type thermoelectric conversion layer (14b) in contact with the second n-type thermoelectric conversion layer (14a), and a fourth electrode (12, 13, 16, 212) electrically connected to the second p-type thermoelectric conversion layer (14b); and
a second sealing layer (15) provided on the fourth main face (11a, 11b), the second sealing layer (15) covering the third electrode (12, 13, 16, 212), the second n-type thermoelectric conversion layer (14a), the second p-type thermoelectric conversion layer (14b), and the fourth electrode (12, 13, 16, 212).

3. The thermoelectric conversion element (1, 1A, 1B, 101, 201) according to claim 2,
wherein the third electrode (12, 13, 16, 212) is overlapped with the first high thermal conduction portion (21, 21-1, 21-2) which each of the pair of sheet members (3A to 3F, 3A-1, 3A-2, 3B-2, 103-1, 103-2) includes and the first electrode (12,13,16,212) in the thickness direction,
wherein the fourth electrode (12, 13, 16, 212) is overlapped with the second high thermal conduction portion (22, 22-1, 22-2) which each of the pair of sheet members (3A to 3F, 3A-1, 3A-2, 3B-2, 103-1, 103-2) includes and the second electrode (12, 13, 16, 212) in the thickness direction, and
wherein a second contact portion (CP) between the second n-type thermoelectric conversion layer (14a) and the second p-type thermoelectric conversion layer (14b) is overlapped with the low thermal conduction portion (23, 23-1, 23-2) which each of the pair of sheet members (3A to 3F, 3A-1, 3A-2, 3B-2, 103-1, 103-2) includes in the thickness direction.

4. The thermoelectric conversion element (1, 1A, 1B, 101, 201) according to claim 2,
wherein the third electrode (12, 13, 16, 212) is overlapped with the second high thermal conduction portion (22, 22-1, 22-2) which each of the pair of sheet members (3A to 3F, 3A-1, 3A-2, 3B-2, 103-1, 103-2) includes and the second electrode (12, 13, 16, 212) in the thickness direction;
wherein the fourth electrode (12, 13, 16, 212) is overlapped with the first high thermal conduction portion (21, 21-1, 21-2) which each of the pair of sheet members (3A to 3F, 3A-1, 3A-2, 3B-2, 103-1, 103-2) includes and the first electrode (12,13,16,212) in the thickness direction, and
wherein a second contact portion (CP) between the second n-type thermoelectric conversion layer (14a) and the second p-type thermoelectric conversion layer (14b) is overlapped with the low thermal conduction portion (23, 23-1, 23-2) which each of the pair of sheet members (3A to 3F, 3A-1, 3A-2, 3B-2, 103-1, 103-2) includes in the thickness direction.

5. The thermoelectric conversion element (1, 1A, 1B, 101, 201) according to any one of claims 2 to 4,
wherein the second thermoelectric conversion module (2A to 2E, 202) is electrically connected to the first thermoelectric conversion module (2A to 2E, 202).

6. The thermoelectric conversion element (1, 1A, 1B, 101, 201) according to any one of claims 2 to 5,
wherein the second sealing layer (15) constitutes an outermost surface located on the fourth main face (11a, 11b).

7. The thermoelectric conversion element (1, 1A, 1B, 101, 201) according to any one of claims 2 to 5, further comprising a sheet member (3A to 3F, 3A-1, 3A-2, 3B-2, 103-1, 103-2) different from the pair of sheet members (3A to 3F, 3A-1, 3A-2, 3B-2, 103-1, 103-2),
wherein the sheet member (3A to 3F, 3A-1, 3A-2, 3B-2, 103-1, 103-2) is located on an opposite side of the first thermoelectric conversion module (2A to 2E, 202) across the second thermoelectric conversion module (2A to 2E, 202) in the thickness direction.

8. The thermoelectric conversion element (1, 1A, 1B, 101, 201) according to any one of claims 1 to 7,
wherein a thermal conductivity of the low thermal conduction portion (23, 23-1, 23-2) is 0.2W/mK or less.

9. The thermoelectric conversion element (1, 1A, 1B, 101, 201) according to claim 8,
wherein the thermal conductivity of the low thermal conduction portion (23, 23-1, 23-2) is 0.08W/mK or less.

10. The thermoelectric conversion element (1, 1A, 1B, 101, 201) according to any one of claims 1 to 9,
wherein each of a thermal conductivity of the first high thermal conduction portion (21, 21-1, 21-2) and a thermal conductivity of the second high thermal conduction portion (22, 22-1, 22-2) is 5W/mK or more.

11. The thermoelectric conversion element (1, 1A, 1B, 101, 201) according to any one of claims 1 to 10,
wherein each of a thermal conductivity of the first electrode (12, 13, 16, 212) and a thermal conductivity of the second electrode (12, 13, 16, 212) is 5W/mK or more.

12. The thermoelectric conversion element (1, 1A, 1B, 101, 201) according to any one of claims 1 to 11,
wherein the substrate (11) has a flexibility.

13. The thermoelectric conversion element (1, 1A, 1B, 101, 201) according to any one of claims 1 to 12,
wherein an interval between the first high thermal conduction portion (21, 21-1, 21-2) and the first contact portion (CP) along the alignment direction is 5 times or more longer than a length of the first high thermal conduction portion (21, 21-1, 21-2) along the thickness direction, and
wherein an interval between the second high thermal conduction portion (22, 22-1, 22-2) and the first contact portion (CP) along the alignment direction is 5 times or more longer than a length of the second high thermal conduction portion (22, 22-1, 22-2) along the thickness direction.

## Patentansprüche

1. Thermoelektrisches Umwandlungselement (1,1A, 1B, 101, 201), das Folgendes umfasst:
ein erstes thermoelektrisches Umwandlungsmodul (2A bis 2E, 202); und
ein Paar von Plattenelementen (3A bis 3F, 3A-1, 3A-2, 3B-2, 103-1, 103-2), die das erste thermoelektrische Umwandlungsmodul (2A bis 2E, 202) sandwichartig einschließen ist,
wobei das erste thermoelektrische Umwandlungsmodul (2A bis 2E, 202) Folgendes umfasst:
ein erstes Substrat (11) mit einer ersten Hauptfläche (11a, 11b) und einer zweiten Hauptfläche (11a, 11b), die sich auf der gegenüberliegenden Seite der ersten Hauptfläche (11a, 11b) befindet;
eine erste Elektrode (12, 13, 16, 212), die auf der ersten Hauptfläche (11a, 11b) vorgesehen ist, eine erste thermoelektrische Umwandlungsschicht vom n-Typ (14a), die elektrisch mit der ersten Elektrode (12, 13, 16, 212) verbunden ist, eine erste thermoelektrische Umwandlungsschicht vom p-Typ (14b), die in Kontakt mit der ersten thermoelektrischen Umwandlungsschicht vom n-Typ (14a) steht, und eine zweite Elektrode (12, 13, 16, 212), die elektrisch mit der ersten thermoelektrischen Umwandlungsschicht vom n-Typ (14b) verbunden ist, und
eine Dichtungsschicht (15), die auf der ersten Hauptfläche (11a, 11b) vorgesehen ist, wobei die Dichtungsschicht (15) die erste Elektrode (12, 13, 16, 212), die erste thermoelektrische Umwandlungsschicht vom n-Typ (14a), die erste thermoelektrische Umwandlungsschicht vom p-Typ (14b) und die zweite Elektrode (12, 13, 16, 212) bedeckt,
wobei jedes des Paars von Plattenelementen (3A bis 3F, 3A-1, 3A-2, 3B-2, 103-1, 103-2) einen ersten hoch wärmeleitenden Abschnitt (21, 21-1, 21-2), einen zweiten hoch wärmeleitenden Abschnitt (22, 22-1, 22-2) und einen niedrig wärmeleitenden Abschnitt (23, 23-1, 23-2) aufweist,
wobei die erste Elektrode (12, 13, 16, 212), die erste thermoelektrische Umwandlungsschicht vom n-Typ (14a), die erste thermoelektrische Umwandlungsschicht vom p-Typ (14b) und die zweite Elektrode (12, 13, 16, 212) in der Reihenfolge entlang einer Ausrichtungsrichtung orthogonal zu einer Dickenrichtung des ersten Substrats (11) angeordnet sind,
wobei die erste Elektrode (12, 13, 16, 212) mit dem ersten hoch wärmeleitenden Abschnitt (21, 21-1, 21-2) überlappt ist, den jedes des Paares von Plattenelementen (3Abis 3F, 3A-1, 3A-2, 3B-2, 103-1, 103-2) in der Dickenrichtung aufweist,
wobei die zweite Elektrode (12, 13, 16, 212) mit dem zweiten hoch wärmeleitenden Abschnitt (22, 22-1, 22-2) überlappt ist, den jedes des Paares von Plattenelementen (3A bis 3F, 3A-1, 3A-2, 3B-2, 103-1, 103-2) in der Dickenrichtung aufweist, und
wobei ein erster Kontaktabschnitt (CP) zwischen der ersten thermoelektrischen Umwandlungsschicht vom n-Typ (14a) und der ersten thermoelektrischen Umwandlungsschicht vom p-Typ (14b) mit dem niedrig wärmeleitenden Abschnitt (23, 23-1, 23-2) überlappt ist, den jedes des Paars von Plattenelementen (3Abis 3F, 3A-1, 3A-2, 3B-2, 103-1, 103-2) in der Dickenrichtung aufweist.

2. Thermoelektrisches Umwandlungselement (1,1A, 1B, 101, 201) nach Anspruch 1, ferner umfassend ein zweites thermoelektrisches Umwandlungsmodul (2A bis 2E, 202), das auf einer gegenüberliegenden Seite des ersten thermoelektrischen Umwandlungsmoduls (2A bis 2E, 202) quer zu einem des Paares von Plattenelementen (3A bis 3F, 3A-1, 3A-2, 3B-2, 103-1, 103-2) in der Dickenrichtung angeordnet ist,
wobei das zweite thermoelektrische Umwandlungsmodul (2A bis 2E, 202) umfasst:
ein zweites Substrat (11) mit einer dritten Hauptfläche (11a, 11b), die auf einer Seite des ersten thermoelektrischen Umwandlungsmoduls (2A bis 2E, 202) in der Dickenrichtung angeordnet ist, und einer vierten Hauptfläche (11a, 11b), die auf einer gegenüberliegenden Seite der dritten Hauptfläche (11a, 11b) angeordnet ist;
eine dritte Elektrode (12, 13, 16, 212), die auf der vierten Hauptfläche (11a, 11b) vorgesehen ist, eine zweite thermoelektrische Umwandlungsschicht vom n-Typ (14a), die elektrisch mit der dritten Elektrode (12, 13, 16, 212) verbunden ist, eine zweite thermoelektrische Umwandlungsschicht vom p-Typ (14b), die in Kontakt mit der zweiten thermoelektrischen Umwandlungsschicht vom n-Typ (14a) steht, und eine vierte Elektrode (12, 13, 16, 212), die elektrisch mit der zweiten thermoelektrischen Umwandlungsschicht vom p-Typ (14b) verbunden ist, und
eine zweite Dichtungsschicht (15), die auf der vierten Hauptfläche (11a, 11b) vorgesehen ist, wobei die zweite Dichtungsschicht (15) die dritte Elektrode (12, 13, 16, 212), die zweite thermoelektrische Umwandlungsschicht vom n-Typ (14a), die zweite thermoelektrische Umwandlungsschicht vom p-Typ (14b) und die vierte Elektrode (12, 13, 16, 212) bedeckt.

3. Thermoelektrisches Umwandlungselement (1, 1A, 1B, 101, 201) nach Anspruch 2,
wobei die dritte Elektrode (12, 13, 16, 212) mit dem ersten hoch wärmeleitenden Abschnitt (21, 21-1, 21-2), den jedes des Paares von Plattenelementen (3A bis 3F, 3A-1, 3A-2, 3B-2, 103-1, 103-2) enthält, und der ersten Elektrode (12, 13, 16, 212) in der Dickenrichtung überlappt ist,
wobei die vierte Elektrode (12, 13, 16, 212) mit dem zweiten hoch wärmeleitenden Abschnitt (22, 22-1, 22-2), den jedes des Paares von Plattenelementen (3Abis 3F, 3A-1, 3A-2, 3B-2, 103-1, 103-2) enthält, und der zweiten Elektrode (12, 13, 16, 212) in der Dickenrichtung überlappt ist, und
wobei ein zweiter Kontaktabschnitt (CP) zwischen der zweiten thermoelektrischen Umwandlungsschicht vom n-Typ (14a) und der zweiten thermoelektrischen Umwandlungsschicht vom p-Typ (14b) mit dem niedrig wärmeleitenden Abschnitt (23, 23-1, 23-2), den jedes des Paars von Plattenelementen (3Abis 3F, 3A-1, 3A-2, 3B-2, 103-1, 103-2) in der Dickenrichtung enthält, überlappt ist.

4. Thermoelektrisches Umwandlungselement (1, 1A, 1B, 101, 201) nach Anspruch 2,
wobei die dritte Elektrode (12, 13, 16, 212) mit dem zweiten hoch wärmeleitenden Abschnitt (22, 22-1, 22-2), den jedes des Paares von Plattenelementen (3Abis 3F, 3A-1, 3A-2, 3B-2, 103-1, 103-2) enthält, und der zweiten Elektrode (12, 13, 16, 212) in der Dickenrichtung überlappt ist;
wobei die vierte Elektrode (12, 13, 16, 212) mit dem ersten hoch wärmeleitenden Abschnitt (21, 21-1, 21-2), den jedes des Paares von Plattenelementen (3A bis 3F, 3A-1, 3A-2, 3B-2, 103-1, 103-2) enthält, und der ersten Elektrode (12, 13, 16, 212) in der Dickenrichtung überlappt ist, und
wobei ein zweiter Kontaktabschnitt (CP) zwischen der zweiten thermoelektrischen Umwandlungsschicht vom n-Typ (14a) und der zweiten thermoelektrischen Umwandlungsschicht vom p-Typ (14b) mit dem niedrig wärmeleitenden Abschnitt (23, 23-1, 23-2) überlappt ist, den jedes des Paars von Plattenelementen (3Abis 3F, 3A-1, 3A-2, 3B-2, 103-1, 103-2) in der Dickenrichtung aufweist.

5. Thermoelektrisches Umwandlungselement (1, 1A, 1B, 101, 201) nach einem der Ansprüche 2 bis 4,
wobei das zweite thermoelektrische Umwandlungsmodul (2A bis 2E, 202) elektrisch mit dem ersten thermoelektrischen Umwandlungsmodul (2A bis 2E, 202) verbunden ist.

6. Thermoelektrisches Umwandlungselement (1, 1A, 1B, 101, 201) nach einem der Ansprüche 2 bis 5,
wobei die zweite Dichtungsschicht (15) eine äußerste Fläche bildet, die sich auf der vierten Hauptfläche (11a, 11b) befindet.

7. Thermoelektrisches Umwandlungselement (1, 1A, 1B, 101, 201) nach einem der Ansprüche 2 bis 5, das ferner ein Plattenelement (3A bis 3F, 3A-1, 3A-2, 3B-2, 103-1, 103-2) umfasst, das sich von dem Paar von Plattenelementen (3A bis 3F, 3A-1, 3A-2, 3B-2, 103-1, 103-2) unterscheidet,
wobei das Plattenelement (3A bis 3F, 3A-1, 3A-2, 3B-2, 103-1, 103-2) auf einer gegenüberliegenden Seite des ersten thermoelektrischen Umwandlungsmoduls (2A bis 2E, 202) quer zu dem zweiten thermoelektrischen Umwandlungsmodul (2A bis 2E, 202) in der Dickenrichtung angeordnet ist.

8. Thermoelektrisches Umwandlungselement (1,1A, 1B, 101, 201) nach einem der Ansprüche 1 bis 7,
wobei die Wärmeleitfähigkeit des niedrig wärmeleitenden Abschnitts (23, 23-1, 23-2) 0,2 W/mK oder weniger beträgt.

9. Thermoelektrisches Umwandlungselement (1,1A, 1B, 101, 201) nach Anspruch 8,
wobei die Wärmeleitfähigkeit des niedrig wärmeleitenden Abschnitts (23, 23-1, 23-2) 0,08 W/mK oder weniger beträgt.

10. Thermoelektrisches Umwandlungselement (1, 1A, 1B, 101, 201) nach einem der Ansprüche 1 bis 9,
wobei die Wärmeleitfähigkeit des ersten hoch wärmeleitenden Abschnitts (21, 21-1, 21-2) und die Wärmeleitfähigkeit des zweiten hoch wärmeleitenden Abschnitts (22, 22-1, 22-2) jeweils 5 W/mK oder mehr beträgt.

11. Thermoelektrisches Umwandlungselement (1,1A, 1B,101, 201) nach einem der Ansprüche 1 bis 10,
wobei die Wärmeleitfähigkeit der ersten Elektrode (12, 13, 16, 212) und die Wärmeleitfähigkeit der zweiten Elektrode (12, 13, 16, 212) jeweils 5 W/mK oder mehr beträgt.

12. Thermoelektrisches Umwandlungselement (1, 1A, 1B, 101, 201) nach einem der Ansprüche 1 bis 11,
wobei das Substrat (11) eine Flexibilität aufweist.

13. Thermoelektrisches Umwandlungselement (1, 1A, 1B, 101, 201) nach einem der Ansprüche 1 bis 12,
wobei ein Abstand zwischen dem ersten hoch wärmeleitenden Abschnitt (21, 21-1, 21-2) und dem ersten Kontaktabschnitt (CP) entlang der Ausrichtungsrichtung 5 mal oder mehr länger ist als eine Länge des ersten hoch wärmeleitenden Abschnitts (21, 21-1, 21-2) entlang der Dickenrichtung, und
wobei ein Abstand zwischen dem zweiten hoch wärmeleitenden Abschnitt (22, 22-1, 22-2) und dem ersten Kontaktabschnitt (CP) entlang der Ausrichtungsrichtung 5 mal oder mehr länger ist als eine Länge des zweiten hoch wärmeleitenden Abschnitts (22, 22-1, 22-2) entlang der Dickenrichtung.

## Revendications

1. Élément de conversion thermoélectrique (1, 1A, 1B, 101, 201) comprenant :
un premier module de conversion thermoélectrique (2A à 2E, 202) ; et
une paire d'éléments de feuille (3A à 3F, 3A-1, 3A-2, 3B-2, 103-1, 103-2) prenant en sandwich le premier module de conversion thermoélectrique (2A à 2E, 202),
dans lequel le premier module de conversion thermoélectrique (2A à 2E, 202) comprend :
un premier substrat (11) comprenant une première face principale (11a, 11b) et une deuxième face principale (11a, 11b) située sur le côté opposé de la première face principale (11a, 11b) ;
une première électrode (12, 13, 16, 212) prévue sur la première face principale (11a, 11b), une première couche de conversion thermoélectrique de type n (14a) connectée électriquement à la première électrode (12, 13, 16, 212), une première couche de conversion thermoélectrique de type p (14b) en contact avec la première couche de conversion thermoélectrique de type n (14a), et une deuxième électrode (12, 13, 16, 212) connectée électriquement à la première couche de conversion thermoélectrique de type p (14b) ; et
une couche d'étanchéité (15) prévue sur la première face principale (11a, 11b), la couche d'étanchéité (15) recouvrant la première électrode (12, 13, 16, 212), la première couche de conversion thermoélectrique de type n (14a), la première couche de conversion thermoélectrique de type p (14b) et la deuxième électrode (12, 13, 16, 212),
dans lequel chacun de la paire d'éléments de feuille (3A à 3F, 3A-1, 3A-2, 3B-2, 103-1, 103-2) comprend une première partie à forte conduction thermique (21, 21-1, 21-2), une deuxième partie à forte conduction thermique (22, 22-1 ,22-2), et une partie à faible conduction thermique (23, 23-1, 23-2),
dans lequel la première électrode (12, 13, 16, 212), la première couche de conversion thermoélectrique de type n (14a), la première couche de conversion thermoélectrique de type p (14b) et la deuxième électrode (12, 13, 16, 212) sont disposées dans l'ordre le long d'une direction d'alignement orthogonale à une direction d'épaisseur du premier substrat (11),
dans lequel la première électrode (12, 13, 16, 212) est chevauchée par la première partie à forte conduction thermique (21, 21-1, 21-2) que chacun de la paire d'éléments de feuille (3A à 3F, 3A-1, 3A-2, 3B-2, 103-1, 103-2) comprend dans la direction d'épaisseur,
dans lequel la deuxième électrode (12, 13, 16, 212) est chevauchée par la deuxième partie à forte conduction thermique (22, 22-1 ,22-2) que chacun de la paire d'éléments de feuille (3A à 3F, 3A-1, 3A-2, 3B-2, 103-1, 103-2) comprend dans la direction d'épaisseur, et
dans lequel une première partie de contact (CP) entre la première couche de conversion thermoélectrique de type n (14a) et la première couche de conversion thermoélectrique de type p (14b) est chevauchée par la partie à faible conduction thermique (23, 23-1, 23-2) que chacun de la paire d'éléments de feuille (3A à 3F, 3A-1, 3A-2, 3B-2, 103-1, 103-2) comprend dans la direction d'épaisseur.

2. Élément de conversion thermoélectrique (1, 1A, 1B, 101, 201) selon la revendication 1, comprenant en outre un deuxième module de conversion thermoélectrique (2A à 2E, 202) situé sur un côté opposé du premier module de conversion thermoélectrique (2A à 2E, 202) à travers l'un de la paire d'éléments de feuille (3A à 3F, 3A-1, 3A-2, 3B-2, 103-1, 103-2) dans la direction d'épaisseur,
dans lequel le deuxième module de conversion thermoélectrique (2A à 2E, 202) comprend :
un deuxième substrat (11) comprenant une troisième face principale (11a, 11b) située sur un côté du premier module de conversion thermoélectrique (2A à 2E, 202) dans la direction d'épaisseur et une quatrième face principale (11a, 11b) située sur un côté opposé de la troisième face principale (11a, 11b) ;
une troisième électrode (12, 13, 16, 212) prévue sur la quatrième face principale (11a, 11b), une deuxième couche de conversion thermoélectrique de type n (14a) connectée électriquement à la troisième électrode (12, 13, 16, 212), une deuxième couche de conversion thermoélectrique de type p (14b) en contact avec la deuxième couche de conversion thermoélectrique de type n (14a), et une quatrième électrode (12, 13, 16, 212) connectée électriquement à la deuxième couche de conversion thermoélectrique de type p (14b) ; et
une deuxième couche d'étanchéité (15) prévue sur la quatrième face principale (11a, 11b), la deuxième couche d'étanchéité (15) recouvrant la troisième électrode (12, 13, 16, 212), la deuxième couche de conversion thermoélectrique de type n (14a), la deuxième couche de conversion thermoélectrique de type p (14b) et la quatrième électrode (12, 13, 16, 212).

3. Elément de conversion thermoélectrique (1, 1A, 1B, 101, 201) selon la revendication 2,
dans lequel la troisième électrode (12, 13, 16, 212) est chevauchée par la première partie à forte conduction thermique (21, 21-1, 21-2) que chacun de la paire d'éléments de feuille (3A à 3F, 3A-1, 3A-2, 3B-2, 103-1, 103-2) comprend et à la première électrode (12, 13, 16, 212) dans la direction d'épaisseur,
dans lequel la quatrième électrode (12, 13, 16, 212) est chevauchée par la deuxième partie à forte conduction thermique (22, 22-1, 22-2) que comprend chacun de la paire d'éléments de feuille (3A à 3F, 3A-1, 3A-2, 3B-2, 103-1, 103-2) et à la deuxième électrode (12, 13, 16, 212) dans la direction d'épaisseur, et
dans lequel une deuxième partie de contact (CP) entre la deuxième couche de conversion thermoélectrique de type n (14a) et la deuxième couche de conversion thermoélectrique de type p (14b) est chevauchée par la partie à faible conduction thermique (23, 23-1, 23-2) que chacun de la paire d'éléments de feuille (3A à 3F, 3A-1, 3A-2, 3B-2, 103-1, 103-2) comprend dans la direction d'épaisseur.

4. Elément de conversion thermoélectrique (1, 1A, 1B, 101, 201) selon la revendication 2,
dans lequel la troisième électrode (12, 13, 16, 212) est chevauchée par la deuxième partie à forte conduction thermique (22, 22-1, 22-2) que comprend chacun de la paire d'éléments de feuille (3A à 3F, 3A-1, 3A-2, 3B-2, 103-1, 103-2) et à la deuxième électrode (12, 13, 16, 212) dans la direction d'épaisseur ;
dans lequel la quatrième électrode (12, 13, 16, 212) est chevauchée par la première partie à forte conduction thermique (21, 21-1, 21-2) que chacun de la paire d'éléments de feuille (3A à 3F, 3A-1, 3A-2, 3B-2, 103-1, 103-2) comprend et à la première électrode (12, 13, 16, 212) dans la direction d'épaisseur, et
dans lequel une deuxième partie de contact (CP) entre la deuxième couche de conversion thermoélectrique de type n (14a) et la deuxième couche de conversion thermoélectrique de type p (14b) est chevauchée par la partie à faible conduction thermique (23, 23-1, 23-2) que chacun de la paire d'éléments de feuille (3A à 3F, 3A-1, 3A-2, 3B-2, 103-1, 103-2) comprend dans la direction d'épaisseur.

5. Élément de conversion thermoélectrique (1, 1A, 1B, 101, 201) selon l'une quelconque des revendications 2 à 4,
dans lequel le deuxième module de conversion thermoélectrique (2A à 2E, 202) est connecté électriquement au premier module de conversion thermoélectrique (2A à 2E, 202).

6. Élément de conversion thermoélectrique (1, 1A, 1B, 101, 201) selon l'une quelconque des revendications 2 à 5,
dans laquelle la deuxième couche d'étanchéité (15) constitue une surface extérieure située sur la quatrième face principale (11a, 11b).

7. Élément de conversion thermoélectrique (1, 1A, 1B, 101, 201) selon l'une quelconque des revendications 2 à 5, comprenant en outre un élément de feuille (3A à 3F, 3A-1, 3A-2, 3B-2, 103-1, 103-2) différent de la paire d'éléments de feuille (3A à 3F, 3A-1, 3A-2, 3B-2, 103-1, 103-2),
dans lequel l'élément de feuille (3A à 3F, 3A-1, 3A-2, 3B-2, 103-1, 103-2) est situé sur un côté opposé du premier module de conversion thermoélectrique (2A à 2E, 202) à travers le deuxième module de conversion thermoélectrique (2A à 2E, 202) dans la direction d'épaisseur.

8. Élément de conversion thermoélectrique (1, 1A, 1B, 101, 201) selon l'une quelconque des revendications 1 à 7,
dans lequel la conductivité thermique de la partie à faible conduction thermique (23, 23-1, 23-2) est inférieure ou égale à 0,2 W/mK.

9. Elément de conversion thermoélectrique (1, 1A, 1B, 101, 201) selon la revendication 8,
dans lequel la conductivité thermique de la partie à faible conduction thermique (23, 23-1, 23-2) est inférieure ou égale à 0,08W/mK.

10. Élément de conversion thermoélectrique (1, 1A, 1B, 101, 201) selon l'une quelconque des revendications 1 à 9,
dans lequel la conductivité thermique de la première partie à forte conduction thermique (21, 21-1, 21-2) et la conductivité thermique de la deuxième partie à forte conduction thermique (22, 22-1, 22-2) sont toutes deux supérieures ou égales à 5 W/mK.

11. Élément de conversion thermoélectrique (1, 1A, 1B, 101, 201) selon l'une quelconque des revendications 1 à 10,
dans lequel la conductivité thermique de la première électrode (12, 13, 16, 212) et la conductivité thermique de la deuxième électrode (12, 13, 16, 212) sont toutes deux supérieures ou égales à 5 W/mK.

12. Élément de conversion thermoélectrique (1, 1A, 1B, 101, 201) selon l'une quelconque des revendications 1 à 11,
dans lequel le substrat (11) est flexible.

13. Élément de conversion thermoélectrique (1, 1A, 1B, 101, 201) selon l'une quelconque des revendications 1 à 12,
dans lequel un intervalle entre la première partie à forte conduction thermique (21, 21-1, 21-2) et la première partie de contact (CP) le long de la direction d'alignement est 5 fois ou plus long que la longueur de la première partie à forte conduction thermique (21, 21-1, 21-2) le long de la direction d'épaisseur, et
dans lequel un intervalle entre la deuxième partie à forte conduction thermique (22, 22-1, 22-2) et la première partie de contact (CP) le long de la direction d'alignement est 5 fois ou plus long qu'une longueur de la deuxième partie à forte conduction thermique (22, 22-1, 22-2) le long de la direction d'épaisseur.
